Europäisches Patentamt

European Patent Office

Office européen des brevets

(19)

(11) **EP 1 289 152 A1**

(12) **EUROPEAN PATENT APPLICATION**
published in accordance with Art. 158(3) EPC

(43) Date of publication:
**05.03.2003 Bulletin 2003/10**

(51) Int Cl.[7]: **H03M 7/30**

(21) Application number: **01932184.3**

(86) International application number:
**PCT/JP01/04250**

(22) Date of filing: **22.05.2001**

(87) International publication number:
**WO 01/095496 (13.12.2001 Gazette 2001/50)**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **06.06.2000 JP 2000168625**

(71) Applicant: **Sakai, Yasue**
**Urawa-shi, Saitama 336-0932 (JP)**

(72) Inventor: **KOYANAGI, Yukio**
**Saitama-shi, Saitama 336-0932 (JP)**

(74) Representative: **VOSSIUS & PARTNER**
**Siebertstrasse 4**
**81675 München (DE)**

(54) **COMPRESSION METHOD AND APPARATUS, EXPANSION METHOD AND APPARATUS, COMPRESSION AND EXPANSION SYSTEM, RECORDED MEDIUM, PROGRAM**

(57)   Data to be compressed is sampled at a time interval of a sampled point where an error is at a desired value or smaller between a data value on a straight line for connecting two pieces of sampled data and a sampled data value corresponding to the data value, and a pair of discrete amplitude data D1, D6, ..., on each sample point and timing data indicative of a time interval between sample points is obtained as compressed data. Hence, from a large number of pieces of sampled data D1, D2, ..., included in data to be compressed, only a pair of amplitude data and timing data can be obtained as compressed data on a sample point where an error from original data is not large even when linear interpolation is performed during expansion. Thus, it is possible to remarkably improve the quality of reproduced data while achieving high compressibility.

FIG. 1A

BETWEEN D1 AND D7

FIG. 1B

BETWEEN D1 AND D6

**Description**

[Background of the Invention]

[Field of the Invention]

The present invention relates to a compressing method and device, an expanding method and device, a compressing and expanding system, a recording medium, and a program, and particularly concerns methods of compressing and expanding a continuous analog signal or digital signal.

[Description of the Related Art]

Conventionally, when transmitting and storing a signal such as a picture signal and an aural signal that has a large amount of information, a signal has been compressed and expanded in order to reduce an amount of transmitted information, increase a storing time of a storage medium, and so on. Generally, when an analog signal is compressed, an analog signal is initially sampled according to a predetermiried sampling frequency and is digitized, and compression is performed on the obtained digital data.

For example, in the case of compression on a picture signal and an aural signal, a method is used in which compression is performed on a frequency region after original data is processed using a conversion filter on a time base-frequency axis such as DCT (Discrete-Cosine-Transform). DPCM (Differential Pulse Code Modulation), which is frequently used as a method of compressing an aural signal for a telephone line, is used with the same intention. Additionally, the DPCM compression is a method for coding a difference of adjacent sample values when a waveform is sampled.

Further, as a method for performing time/frequency conversion, a method using a sub-band filter and MDCT (Modified Discrete Cosine Transform) is also available. As a coding method using such a method, MPEG (Moving Picture Image Coding Experts Group) audio is applicable.

Further, the most widely used picture compressing system is generally known as the MPEG standard.

Data compressed by the above compressing method is basically expanded according to reversed operations of the same compressing method.

Namely, after compressed digital data is converted from a signal of a frequency region to a signal of a time region by frequency/time conversion, predetermined expanding operations are carried out to reproduce original digital data. And then, the original data obtained thus is subjected to digital-analog conversion if necessary and is outputted as an analog signal.

Generally, in the case of compression and expansion of data, it is important to consider how to improve the quality of reproduced data while improving its compressibility. However, in the above conventional compressing and expanding method, when a compressibility of a picture signal and an aural signal is increased, an image and voice reproduced by expanding compressed data are degraded in quality. In contrast, when importance is placed on the quality of a reproduced image and reproduced voice, a picture signal and an aural signal decreases in compressibility. Therefore, it has been extremely difficult to achieve both of an increased compressibility and improved quality of reproduced data.

Further, in the above conventional compressing and expanding method, a signal on a time base is converted to a signal on a frequency axis before compression. Hence, operations such as time/frequency conversion for compression and frequency/time conversion for expansion are necessary. Therefore, the operations are complicated and the configuration for realizing the operations becomes extremely complicated. This problem has caused not only a longer processing time for compression and expansion but also difficulty in achieving a smaller device.

The present invention is devised to solve the above problems and aims to provide completely new compressing and expanding methods for realizing both of an increased compressibility and improved quality of reproduced data.

Also, another object of the present invention is to simplify the compressing and expanding operations for a signal so as to shorten a processing time and to simplify the configuration for realizing the operations.

[Summary of the Invention]

In order to solve the above problems, on a compression side of the present invention, as sample points, sampled points are sequentially detected, each having an error from original data at a desired value or smaller when interpolation is performed between two pieces of sampled data included in data to be compressed, and sampled data on each detected sample point is used to generate compressed data.

Further, on an expansion side, sampled data on each sample point is obtained from compressed data and an interpolating operation is carried out. Interpolation data for interpolating sample points is determined to obtain expansion data.

In another aspect of the present invention, on a compression side, a linear interpolating operation is performed as an interpolating operation for discriminating if an error is at a desired value or smaller. Moreover, on an expansion side, linear interpolation is performed as an interpolating operation for obtaining interpolation data.

In another aspect of the present embodiment, on a compression side, regarding time intervals on sampled points where errors are all at a desired value or smaller between data values on a straight line for connecting two pieces of sampled data and sampled data values on the same sampled points as the data values on the straight line, a sampled point having a maximum time interval between the two pieces of sampled data within a predetermined range is selected as a sample point of compressed data.

In another aspect of the present invention, on a compression side, regarding sampled points where errors are all at a desired value or smaller between data values on a straight line for connecting two pieces of sampled data and sampled data values on the same sampled points as the data values on the straight line, a sampled point just before a sampled point where the error exceeds the desired value is detected as a sample point of compressed data.

In another aspect of the present invention, time intervals between the two pieces of sampled data, which is adopted upon error discrimination for detecting a sample point, are discontiguous in a range wider than a predetermined interval.

In another aspect of the present invention, an error tolerance value is dynamically changed as a function of at least one of amplitude and frequency of data to be compressed.

In another aspect of the present invention, on a compression side, a lower-order bit of the data to be compressed is rounded, and a pair of amplitude data on the rounded sample point and timing data indicative of a time interval between sample points is obtained as compressed data.

In another aspect of the present invention, on a compression side, a pair of amplitude difference data, which is obtained by computing a difference between pieces of amplitude data on the sample point, and timing data, which is indicative of a time interval between sample points, is obtained as compressed data.

In another aspect of the present invention, on a compression side, sampled data having an absolute value smaller than a predetermined value in data to be compressed is replaced with zero data. Compressed data on zero data sets a value of timing data at 0 and sets a value of amplitude data at a value indicative of a time interval of continuous zero data. On an expansion side, when timing data constituting the compressed data has a value of 0, a value of expansion data is set at 0 for a time interval indicated by a value of amplitude data.

Since the present invention is constituted by the above technical means, from a large number of pieces of sampled data included in data to be compressed, a sample point is detected, on which an error from original data is not large even when interpolation is performed during expansion. For example, only a pair of discrete amplitude data on sample point and timing data indicative of a time interval between sample points is generated as compressed data, thereby remarkably improving the quality of data reproduced by expansion while achieving high compressibility.

Further, according to the present invention, when a signal on a time base is compressed, the operation can be performed on a time base without time/frequency conversion on a frequency axis. Besides, when data compressed thus is expanded as well, the operation can be performed on a time base. Particularly on the expansion side, it is possible to reproduce highly accurate expansion data, which is hardly different from original data before compression, merely by interpolation, which is quite a simple operation.

According to another characteristic of the present invention, since a linear interpolating operation is performed as an interpolating operation, compression and expansion can be carried out only by linear interpolation, which is a particularly simple interpolating operation.

According to another characteristic of the present invention, on the compression side, a sampled point having a maximum time interval between two pieces of sampled data within a predetermined range is sequentially detected as a sample point of compressed data. Thus, it is possible to contain individual timing data values within predetermined bits and to minimize the number of detected sample points, thereby improving compressibility accordingly.

According to another characteristic of the present invention, a sampled point just before a sampled point where an error exceeds a desired value is sequentially detected as a sample point of compressed data. Hence, it is possible to maximize an interval between sample points and to minimize the number of detected sample points, thereby achieving high compressibility.

According to another characteristic of the present invention, time intervals between the two pieces of sampled data, which is adopted upon error discrimination for detecting a sample point, are discontiguous in a range wider than a predetermined interval. Thus, it is possible to increase a maximum width of a time interval between the two pieces of sampled data without increasing the number of times of error discrimination for detecting a sample point. Therefore, without delay in discriminating time, it is possible to maximize an interval between sample points and to minimize the number of detected sample points. Moreover, time intervals between the two pieces of sampled data are continuous in a range smaller than a predetermined interval. Hence, it is possible to perform accurate error discrimination in a range where the error condition is satisfied frequently, thereby minimizing the number of detected sample points.

According to another characteristic of the present invention, an error tolerance value is dynamically changed as an amplitude function of data to be compressed. For example, an error tolerance value is increased on a part having large amplitude and is decreased at a part having small amplitude. Therefore, it is possible to maximize an interval between sample points to minimize the number of detected sample points on a part having large amplitude, on which even a large error is not visible. Meanwhile, on a part having small amplitude on which an error is relatively visible, it is possible to suppress an increase in error. Hence, it is possible to further increase compressibility while maintaining the good quality of expansion data.

According to another characteristic of the present invention, an error tolerance value is dynamically changed as a frequency function of data to be compressed. For example, an error tolerance value is increased on a part having a high frequency and is decreased on a part having a low frequency. Thus, an interval between sample points can be maximized to minimize the number of detected sample points, on a part having a high frequency in a series of pieces of data inputted to be compressed, that is, on a part having a relatively large change in sampled data value even on an adjacent sampled point. Meanwhile, on a part having a low frequency, that is, on a part having a small change in sampled data value on an adjacent sampled point, it is possible to suppress a large increase in error. Therefore, compressibility can be further improved while the good quality of expansion data is maintained.

According to another characteristic of the present invention, a rounding operation is performed on a lower-order bit of data to be compressed or amplitude data on a sample point. Thus, it is possible to shorten a data length by several bits per word, thereby largely reducing an amount of data. At this moment, digital data to be rounded is concentrated onto a part of the entire data region expressed by the number of bits but hardly appears on a data region around the ends. Hence, even when a lower-order bit of such data is rounded, the quality of reproduced data is hardly affected.

According to another characteristic of the present invention, instead of directly using amplitude data on detected sample points as compressed data, difference data is further obtained as compressed data. Thus, it is possible to further reduce the number of bits required for compressed data, resulting in a smaller amount of data.

According to another characteristic of the present invention, a value of 0, which is not used as a timing data value normally, is used in a mute state (zero data). Thus, zero data having a time interval can be compressed to a pair of an amplitude data value and a timing data value, thereby further reducing an amount of data.

[Brief Description of the Drawings]

Figure 1A and 1B are diagrams for explaining a basic principle of a compressing method according to the present embodiment;

Figure 2 is a block diagram showing an example of the functional configuration of a compressing device according to Embodiment 1;

Figure 3 is a block diagram showing an example of the functional configuration of an expanding device according to Embodiment 1;

Figure 4 is a circuit diagram showing an example of the configuration of a differentiator in which the function of an error arithmetic section of Figure 2 is partly realized by hardware;

Figure 5A to 5E are diagrams showing an example of the configuration of a circuit in which the function of the error arithmetic section of Figure 2 is partly realized by hardware;

Figure 6A to 6E are diagrams showing an example of the configuration of a circuit in which the function of a sample point detecting section of Figure 2 is partly realized by hardware;

Figure 7 is a diagram showing an example of the configuration of a circuit in which the function of the sample point detecting section of Figure 2 is partly realized by hardware;

Figure 8 is a timing chart showing the operation performed in a part of the circuit shown in Figure 7;

Figure 9A and 9B are diagrams for explaining an error arithmetic;

Figure 10 is a diagram showing an example of the configuration of a circuit in which hardware realizes the function of an interpolating section of the expanding device shown in Figure 3;

Figure 11 is a block diagram showing an example of the functional configuration of a compressing device according to Embodiment 2;

Figure 12 is a diagram for explaining an example of a nonlinear rounding operation;

Figure 13 is a diagram for explaining another example of the nonlinear rounding operation;

Figure 14 is a block diagram showing an example of the functional configuration of an expanding device according to Embodiment 2;

Figure 15 is a diagram for explaining an example of a nonlinear reverse rounding operation;

Figure 16 is a diagram for explaining another example of the nonlinear reverse rounding operation;

Figure 17 is a diagram showing an example of the configuration of a circuit in which hardware realizes the function of a mute processing section shown in Figure 11;

Figure 18 is a diagram showing an example of the configuration of a circuit in which hardware realizes the functions of a rounding section and an amplitude difference data generating section shown in Figure 11;

Figure 19 is a diagram showing an example of the configuration of a circuit for performing the nonlinear rounding operation of Figure 13;

Figure 20 is a diagram showing an example of the configuration of a circuit in which hardware realizes the functions of an interpolating section and a reverse rounding section of the expanding device shown in Figure 14;

Figure 21 is a diagram showing an example of the configuration of a circuit for performing the nonlinear reverse rounding operation of Figure 16;

Figure 22A and 22B are diagrams for comparing original data before compression and data reproduced by expansion in Embodiment 2;

Figure 23A and 23B are diagrams for comparing original data before compression and data reproduced by expansion in Embodiment 2; and

Figure 24A and 24B are diagrams for comparing original data before compression and data reproduced by expansion in Embodiment 2.


[Detailed Description of the Preferred Embodiments]

(Embodiment 1)

The following will discuss an embodiment of the present invention in accordance with the accompanied drawings.

In a compressing method of the present embodiment, first, when an analog signal is inputted as a signal to be compressed, the inputted analog signal is subjected to A/D conversion and is converted to digital data. And then, the obtained digital data undergoes the following operations. Further, when digital data is inputted as a signal to be compressed, the following operations are directly performed on the digital data.

Namely, from sampled points of data to be compressed, as sample points, sampled points are sequentially detected where an error is at a predetermined value or smaller between a data value on a straight line for connecting two pieces of sampled data and a sampled data value on the same sampled point as the data value on the straight line. And then, a value of discrete amplitude data on each detected sample point and a timing data value indicative of a time interval between sample points are determined, and a pair of the amplitude data value and the timing data value is transmitted or recorded as compressed data.

The operation of detecting a sample point will be specifically discussed as below. Namely, from data to be compressed, reference sampled data and another piece of sampled data, which has a time interval from the reference sampled data within a predetermined range, are selected. Subsequently, sampled points are detected where errors are all at a predetermined value or smaller between data values on a straight line for connecting the two pieces of sampled data and sampled data values disposed on the same sampled points as the data value on the straight line, and the sampled point having a maximum time interval within the predetermined range is detected as a sample point.

Meanwhile, in an expanding method for expanding compressed data generated thus according to the present embodiment, an interpolating operation for linearly interpolating pieces of amplitude data on successive sample points is performed sequentially based on inputted compressed data (a pair of an amplitude data value and a timing data value). Thus, interpolation data is generated for interpolating individual amplitude data values. Further, generated interpolation data is subjected to D/A conversion as necessary and is converted to an analog signal, and the analog signal is outputted.

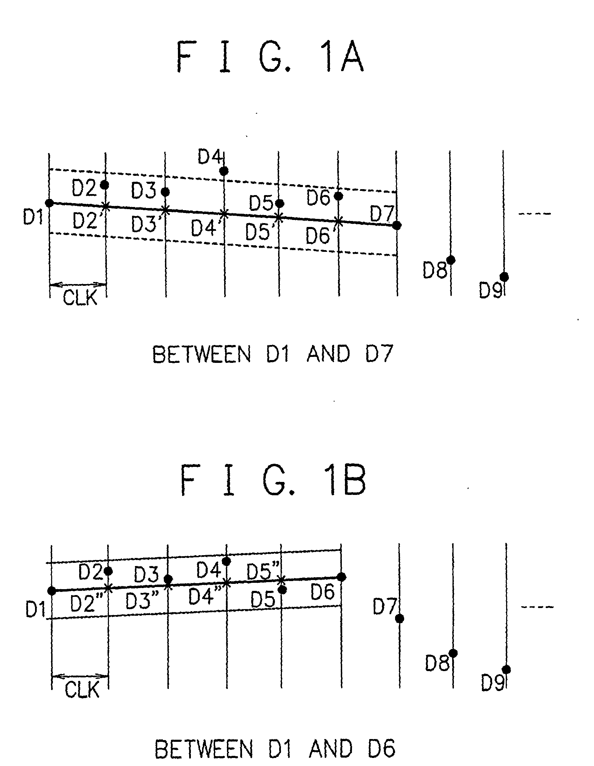

Figure 1A and 1B are diagrams for explaining a basic principle of the compressing method according to the present embodiment. In Figure 1A and 1B, a lateral axis represents time and a vertical axis represents amplitude of sampled data. D to D9 of Figure 1A and 1B are parts of sampled data obtained by sampling data to be compressed for each predetermined clock CLK. In the example of Figure 1A and 1B, sampled data D1 is reference sampled data, which is firstly adopted. Moreover, a time interval between two pieces of sampled data selected for detecting a sample point ranges up to six clocks. Additionally, when three bits or four bits are used as timing data values, a time interval between pieces of sampled data is set at seven clocks or 15 clocks at the maximum.

First, as shown in Figure 1A, reference sampled data D1 and sampled data D7 having a maximum time interval therefrom within a predetermined range are selected. And then, determination is made if errors are all at a predetermined value or smaller between data values D2', D3', D4', D5', and D6' of sampled points on a straight line for connecting the two pieces of sampled data and sampled data values D2, D3, D4, D5, and D6 on the same sampled points as the data values D2' to D6' on the straight line.

Namely, determination is made if errors are all within a range of desired values indicated by dotted lines between data values D2', D3', D4', D5', and D6' on the straight line for connecting the two pieces of sampled data D1 and D7 and sampled data values D2, D3, D4, D5, and D6. When the above condition is satisfied, sampled data D7 is detected as a sample point. However, in this example, an error between a data value D4' on the straight line and the corresponding sampled value D4 exceeds a desired value. Hence, sampled data D7 is not adopted as a sample point at this moment, and operation proceeds to the next.

Next, as shown in Figure 1B, sampled data D6 whose time interval from reference sampled data D1 is shorter than that of sampled data D7 by one clock CLK is selected. Subsequently, determination is made if errors are all at a predetermined value or smaller between data values D2", D3", D4", and D5" of sampled points on a straight line for connecting two pieces of sampled data D1 and D6 and sampled data values D2, D3, D4, and D5 on the same sampled points as the data values D2" to D5" on the straight line.

And then, when all the errors are at a desired value or smaller, sampled data D6 is detected as a sample point. In this example, all the errors between data values D2", D3", D4", and D5" on the straight line and sampled data values D2, D3, D4, and D5 are at a desired value or smaller. Thus, sampled data D6 is detected as a sample point.

Here, regarding straight lines between D1 and D7, D1 and D6, ..., D1 and D3, when any of them does not satisfy the condition that all the errors are at a desired value or smaller, the sampled point of sampled data D2 is detected as a sample point. Namely, since other sampled data does not exist between sampled data D1 and D2, the above error arithmetic is not necessary for this section. Therefore, when any of the straight lines connecting the other sections does not satisfy the error condition, the position of sampled data D2, which is adjacent to current reference sampled data D is detected as a sample point.

After a sample point is detected, the sample point is additionally used as reference sampled data, and the above operations are performed within a range of six clocks from the sample point. Hence, within a range of six clocks from sampled data D6, all the errors are at a desired value or smaller, and a sampled point having a maximum time interval from sampled data D6 is detected as a subsequent sample point.

In a similar manner, a plurality of sample points are detected in order. And then, a pair of a discrete amplitude data value on each detected sample point and a timing data value, which indicates a time interval between sample points by the number of clocks, is obtained as compressed data. In the above example, pairs of (D1, 5), (D6, *), ... including amplitude data values (D1, D6, ... ) on the sample points and timing data values (5, *, ...) are obtained as compressed data.

Here, what has been described is an example in which a sampled point having a maximum time interval within a predetermined range between two pieces of sampled data (sampled data D1 and D7) is firstly selected to start error discrimination, and the operation proceeds while time intervals are shortened in order. The method of detecting a sample point is not limited to the above.

For example, a sampled point having a minimum time interval between two pieces of sampled data (sampled data D1 and D3) within a predetermined range may be firstly selected to start error discrimination, and the operation may proceed for longer time intervals in order. Further, a sampled point having a time interval between two pieces of sampled data (e.g., sampled data D1 and D4) around the center of a predetermined range may be selected to start error discrimination. Moreover, error discrimination may be performed on all the possible patterns of time intervals within a predetermined range, and then, a pattern having a maximum time interval may be selected from patterns satisfying the error condition.

Meanwhile, a basic principle of expansion of the present embodiment (not shown) is to just linearly interpolate pieces of amplitude data at a time interval indicated by timing data, on sample points of compressed data generated thus.

In compression of the present embodiment, when two pieces of sampled data are linearly interpolated, errors are detected between an interpolated straight line and other sampled data between the two pieces of sampled data, and then, a point not having a large error after linear interpolation is detected as a sample point. Therefore, simply by just linearly interpolating pieces of amplitude data on sample points obtained thus, it is possible to reproduce data having substantially the same waveform as original data before compression.

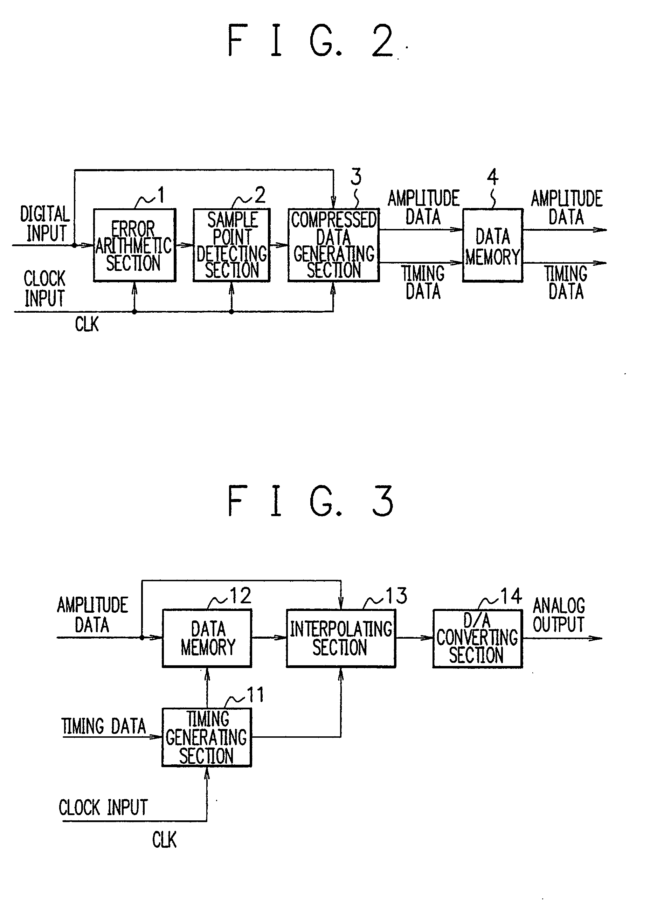

Figure 2 is a block diagram showing an example of the functional configuration of a compressing device according to Embodiment 1 for realizing the above compressing method. The compressing device of Figure 2 is applicable, for example, when a digital aural signal is compressed. Besides, the device can also be used for an analog aural signal by providing an A/D converter on an input stage.

As shown in Figure 2, the compressing device of the present embodiment is constituted by an error arithmetic section 1, a sample point detecting section 2, a compressed data generating section 3, and a data memory 4.

The error arithmetic section 1 selects a pair of reference sampled data and another sampled data having a time interval therefrom within a predetermined range (for example, within seven clocks when a timing data value is three bits, within 15 clocks when a timing data value is four bits, and herein after. a six-clock range will be used in accordance with Figure 1A and 1B) from inputted digital data to be compressed. Errors are computed between data values on a straight line for connecting the selected two pieces of sampled data and sampled data values on the same sampled points as data values on the straight line.

The error arithmetic section 1 performs such error arithmetic by selecting a plurality of pairs of reference sampled data and another sampled data obtained therefrom within a predetermined range. Namely, in the example of Figure 1A and 1B, errors on sampled points are computed respectively for straight lines between D and D7 , between D and D6 , between D1 and D5, ..., and between D1 and D3.

Moreover, as a sample point, the sample point detecting section 2 detects a sampled point having a maximum time interval from reference sampled data, from sampled points which form a straight line having all the errors on sampled points at a desired value or smaller, the errors being computed by the error arithmetic section 1. In the example of Figure 1A and 1B, as described above, when sampled data D1 is used as reference sampled data, the sampled point on D6 is detected as a sample point.

After a sample point is detected thus, the error arithmetic section 1 and the sample point detecting section 2 perform the same operations within a range of six clocks from reference sampled data while the detected sample point is newly used as reference sampled data. In this manner, the error arithmetic section 1 and the sample point detecting section 2 sequentially detect a plurality of sample points.

In the example of Figure 1A and 1B, the error arithmetic section 1 performs all the error computations for a plurality of straight lines which can be drawn from one reference sampled data. Therefore, two or more sampled points satisfying the error condition may be detected. In this case, as a sample point, the sample point detecting section 2 detects a sampled point having a maximum time interval from reference sampled data, from two or more sampled points satisfying the error condition. Hence, it is possible to minimize the number of detected sample points, thereby increasing compressibility.

Additionally, as described in accordance with Figure 1A and 1B, the following operation is also applicable: sampled points having longer time intervals from reference sampled data are selected in order, determination is made if the error condition is satisfied, and a sampled point satisfying the condition is detected as a sample point.

The compressed data generating section 3 obtains a pair of a value of discrete amplitude data on each sample point, which is detected by the sample point detecting section 2, and a timing data value indicative of a time interval between sample points. A pair of the amplitude data value and the timing data value is obtained as compressed data. And then, compressed data generated thus, which has a pair of an amplitude data value and a timing data value, is stored in the data memory 4. Compressed data stored in the data memory 4 is transmitted to a transmission line or is recorded in a recording medium.

Subsequently, the following will discuss an expanding device for the above-mentioned compressing device.

Figure 3 is a block diagram showing an example of the functional configuration of the expanding device according to the present embodiment. As shown in Figure 3, the expanding device of the present embodiment is constituted by a timing generating section 11, a data memory 12, an interpolating section 13, and a D/A converting section 14.

The timing generating section 11 inputs timing data included in compressed data and generates a reading clock, which is indicative of a time interval as irregular as sample points detected on the compression side, from an input clock CLK. The data memory 12 sequentially captures and stores amplitude data included in compressed data at timing according to a reading clock generated by the timing generating section 11, and the data memory 12 outputs the amplitude data to the interpolating section 13.

Amplitude data on an input/output stage of the data memory 12, that is, amplitude data stored in the data memory 12 at timing of a reading clock, and amplitude data to be stored in the data memory 12 at timing of the subsequent reading clock (two pieces of amplitude data on two successive sample points) are inputted to the interpolating section 13.

The interpolating section 13 performs an operation for linearly interpolating two pieces of amplitude data by using two pieces of amplitude data inputted thus and timing data inputted from the timing generating section 11, and generates digital interpolation data between sample points. Digital interpolation data generated thus is converted to an analog signal by the D/A converting section 14 and is outputted as a reproduced analog signal.

The compressing device and the expanding device configured thus according to the present embodiment are constituted by a computer system having a CPU or an MPU, a ROM, RAM, and so on. The functions of the devices are realized by operating programs stored in the above ROM, RAM, and so on.

Further, the compressing device and the expanding device configured thus according to the present embodiment may be configured as hardware by combining logic circuits.

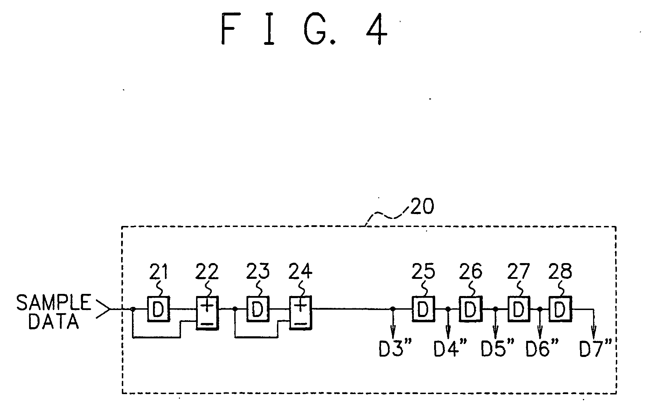

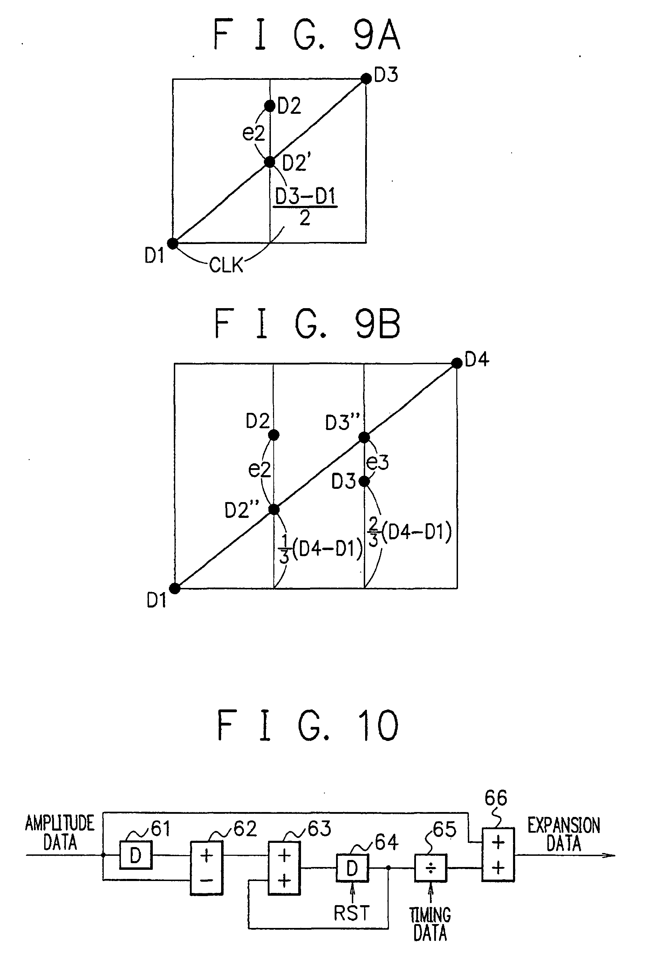

Figures 4 to 8 are diagrams showing examples of the hardware structure of the compressing device according to the present embodiment. Before explanation in accordance with Figures 4 to 8, the following will discuss a method of computing an error between a data value on a straight line for connecting two pieces of sampled data and a sampled data value on the same sampled point as the data value, in accordance with Figure 9.

Figure 9A is a diagram showing an error e2 when reference sampled data D1 and sampled data D3, which is apart from sampled data D1 by two clocks, are connected by a straight line.

In Figure 9A, an error e2 between sampled data D2, which is provided between data D1 and D3, and data D2' on a straight line for connecting data D1 and D3 is expressed by the following equation (1).

$$e2 = (D2 - D1) - (D3 - D1)/2$$

$$2e2 = 2D2 - 2D1 - D3 + D1$$
$$= 2D2 - D1 - D3$$
$$= (D2 - D1) - (D3 - D2)$$
$$= D2' - D3'$$

$$e2 = -(D3' - D2')/2 = -D3''/2 \qquad (1)$$

Here, in the above equation (1), 'indicates a first differential value, and " indicates a second differential value. As shown in the above equation (1), when a straight line has a time interval of two clocks, an error e2 can be expressed by a double differential value of sampled data D3. Therefore, when tolerance is set at ?, the sample point detecting section 2 of Figure 2 discriminates if the discriminating condition of |e2| ? ? is satisfied. Here, || indicates an absolute value.

Figure 9B is a diagram showing two errors e2 and e3 when reference sampled data D1 and sampled data D4, which is apart from sampled data D1 by three clocks, are connected by a straight line.

In Figure 9B, the following equations (2) and (3) respectively represent errors e2 and e3 between sampled data D2 and D3, which are provided between data D1 and D4, and data D2" and D3" on a straight line for connecting data D1 and D4.

$$e2 = (D2 - D1) - (D4 - D1)/3$$

$$3e2 = 3D2 - 3D1 - D4 + D1$$
$$= 3D2 - 2D1 - D4$$
$$= 2(D2 - D1) - (D4 - D2)$$
$$= 2(D2 - D1) - (D4 - D3) - (D3 - D2)$$
$$= 2D2' - D4' - D3'$$
$$= -(D4' - D3') - 2(D3' - D2')$$
$$= -D4'' - 2D3''$$

$$e2 = -1/3\{D4'' + 2D3''\} \qquad (2)$$

$$e3 = (D3 - D1) - 2(D4 - D1)/3$$

$$3e3 = 3D3 - 3D1 - 2D4 + 2D1$$

$$= 3D3 - D1 - 2D4$$

$$= -2(D4 - D3) + (D3 - D1)$$

$$= -2(D4 - D3) + (D3 - D2) + (D2 - D1)$$

$$= -2D4' + D3' + D2'$$

$$= -2(D4' - D3') - (D3' - D2')$$

$$= -2D4'' - D3''$$

$$e3 = -1/3\{2D4'' + D3''\} \tag{3}$$

As shown in the above equations (2) and (3), when a straight line has a time interval of three clocks, errors e2 and e3 can be expressed by double differential values of sampled data D3 and D4. In this case, the sample point detecting section 2 of Figure 2 discriminates if the discriminating conditions of $|e2| ? ?$ and $|e3| ? ?$ are satisfied. Besides, a larger error of errors e2 and e3 may be discriminated firstly, and then, by using only larger one, determination may be made if the discriminating condition is satisfied.

In a similar manner, when a straight line has a time interval of four clocks, errors e2, e3, and e4 are expressed by the following equations (4) to (6) using double differential values of sampled data D3, D4, and D5.

$$e2 = -1/4 \{D5'' + 2D4'' + 3D3''\} \tag{4}$$

$$e3 = -1/4 \{2D5'' + D4'' + 2D3''\} \tag{5}$$

$$e4 = -1/4 \{3D5'' + 2D4'' + D3''\} \tag{6}$$

In this case, the sample point detecting section 2 of Figure 2 discriminates if the discriminating conditions of $|e2| ?$, $|e3| ? ?$, and $|e4| ? ?$ are satisfied. Besides, the largest error of errors e2, e3, and e4 may be discriminated firstly, and then, by using only the largest one, determination may be made if the discriminating conditions are satisfied

In a similar manner, when a straight line has a time interval of five clocks, errors e2, e3, e4, and e5 can be expressed by the following equations (7) to (10) using double differential values of sampled data D3, D4, D5, and D6.

$$-e2 = 1/5 \{D6'' + 2D5'' + 3D4'' + 4D3''\} \tag{7}$$

$$-e3 = 1/5 \{2D6'' + 4D5'' + 6D4'' + 3D3''\} \tag{8}$$

$$-e4 = 1/5 \{3D6'' + 6D5'' + 4D4'' + 2D3''\} \tag{9}$$

$$-e5 = 1/5 \{4D6'' + 3D5'' + 2D4'' + D3''\} \tag{10}$$

In this case, the sample point detecting section 2 of Figure 2 discriminates if the discriminating conditions of $|e2| ? ?$, $|e3| ? ?$, $|e4| ? ?$, and $|e5| ? ?$ are satisfied. Besides, the largest error of errors e2, e3, e4, and e5 may be discriminated firstly, and then, by using only the largest one, determination may be made if the discriminating conditions are satisfied.

In a similar manner, when a straight line has a time interval of six clocks, errors e2, e3, e4, e5, and e6 can be expressed by the following equations (11) to (15) using double differential values of sampled data D3, D4, D5, D6, and D7.

$$e2= -1/6 \{D7'' + 2D6'' + 3D5'' + 4D4'' + 5D3''\} \tag{11}$$

$$e3= -1/6 \{2D7'' + 4D6'' + 6D5'' + 8D4'' + 4D3''\} \tag{12}$$

$$e4= -1/6 \{3D7'' + 6D6'' + 9D5'' + 6D4'' + 3D3''\} \tag{13}$$

$$e5= -1/6 \{4D7'' + 8D6'' + 6D5'' + 4D4'' + 2D3''\} \tag{14}$$

$$e6= -1/6 \{5D7'' + 4D6'' + 3D5'' + 2D4'' + D3''\} \tag{15}$$

In this case, the sample point detecting section 2 of Figure 2 discriminates if the discriminating conditions of |e2| ? ?, |e3| ? ?, |e4| ? ?, |e5| ? ?, and |e6| ? ? are satisfied. Besides, the largest one of errors e2, e3, e4, e5, and e6 may be discriminated firstly, and then, by using only the largest one, determination may be made if the discriminating conditions are satisfied.

As shown in the above equations (1) to (15), all of error data used in the compression of the present embodiment can be computed simply by using double differential values of sampled data. Therefore, the compressing device of Figures 4 to 8 uses a differentiator as a hardware structure for obtaining error data.

Figure 4 is a circuit diagram showing an example of the configuration of a differentiator 20, which realizes a part of the function of the error arithmetic section 1 of Figure 2 by using a hardware structure. As shown in Figure 4, the differentiator 20 includes a first differentiator composed of a D-type flip flop 21, which stores sampled data inputted sequentially in each clock, and a subtractor 22, which subtracts current sampled data from sampled data delayed by one clock in the D-type flip flop 21.

Further, the differentiator 20 includes a second differentiator composed of a D-type flip flop 23, which stores a differential value outputted sequentially from the first differentiator in each clock, and a subtractor 24, which subtracts a current differential value from a differential value delayed by one clock in the D-type flip flop 23.

Additionally, four D-type flip flops 25 to 28 are connected to the subsequent stage of the second differentiator (subtracter 24), and double differential values of sampled data that are sequentially outputted from the subtracter 24 are conveyed while being delayed by one clock. And then, pieces of data corresponding to the above-mentioned double differential values D3'', D4'', D5'', D''6, and D7'' are respectively outputted from the taps of the input/output stages of the D-type flip flops 25 to 28.

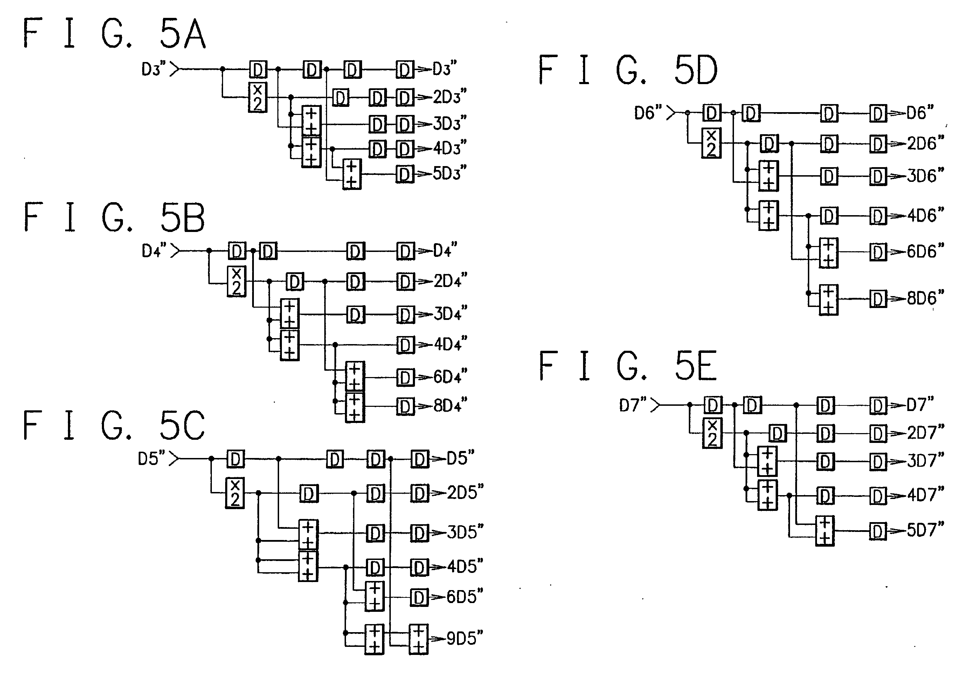

Figure 5A to 5E are diagrams showing examples of circuits for computing data values used in the above equations (1) to (15) from data of double differential values D3'', D4'', D5'', D6'', and D7'', which are outputted from the double differentiator 20 of Figure 4. Figure 5A shows a circuit for computing necessary data from a double differential value D3''. Figure 5B shows a circuit for computing necessary data from a double differential value D4''. Figure 5C shows a circuit for computing necessary data from a double differential value D5''. Figure 5D shows a circuit for computing necessary data from a double differential value D6''. Figure 5E shows a circuit for computing necessary data from a double differential value D7''.

The circuits shown in Figures 5A to 5E are all formed by suitably combining one or more multipliers and adders, which are provided for multiplying double differential values D3'', D4'', D5'', D6'', and D7'' by an integer, and one or more D-type flip flops provided for adjusting timing of outputting double differential values, which are multiplied by an integer, to a circuit on the subsequent stage.

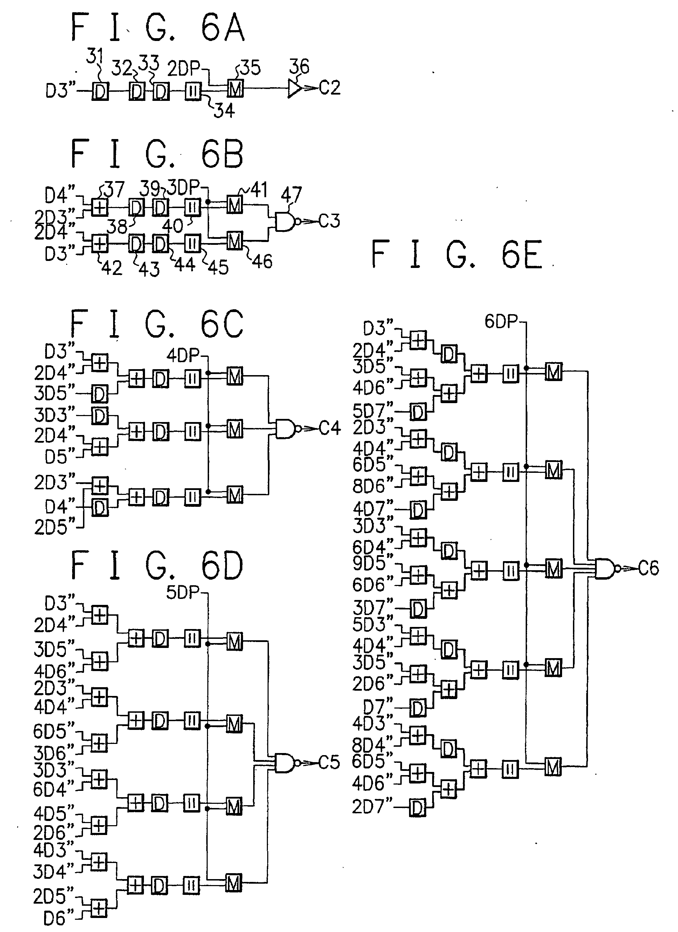

Figure 6A to 6E are diagrams showing an example of a circuit in which a part of the function of the sample point detecting section 2 of Figure 2 is realized by a hardware structure. Figure 6A is a circuit for discriminating if an error e2 between a data value D2' and sampled data D2 on a straight line is at a desired value or smaller when sampled data D1 and D3 are connected by the straight line.

In Figure 6A, a double differential value D3'' of sampled data D3, which is inputted from the circuit of Figure 5A, is sequentially delayed by one clock in three D-type flip flops 31 to 33 provided for adjusting timing, and the double differential value D3 is supplied to an absolute value circuit 34. The absolute value circuit 34 determines an absolute value of a supplied double differential value, and supplies the result to one of the input terminals of an amplitude comparator 35. The above operation determines an absolute value of a value obtained by doubling error e2, which is shown in the above equation (1).

A value obtained by doubling an error tolerance value DP is inputted to the other input terminal of the amplitude comparator 35. The amplitude comparator 35 compares a doubled error e2 and a doubled error tolerance value DP. Here, comparison is made using doubled values for the convenience of a circuit. Substantially, error e2 and an error tolerance value DP are compared with each other.

And then, the amplitude comparator 35 outputs a signal of "L" when error e2 is larger than an error tolerance value DP, and the amplitude comparator 35 outputs a signal of "H" when error e2 is at an error tolerance value DP or smaller. A signal of "H" or "L" outputted from the amplitude comparator 35 is outputted as an error discrimination signal C2 via an inverter 36. Thus, when error e2 of equation (1) is within a range of an error tolerance value DP, an error discrimination signal C2 at "L" level is outputted as a pulse signal.

Figure 6B shows a circuit for discriminating if error e2 between data values D2" and D3", which are provided on the straight line, and error e3 between sampled data D2 and D3 are at a desired value or smaller when sampled data D1 and D4 are connected by a straight line.

In Figure 6B, double differential values D4" and 2D3" inputted from the circuits of Figures 5A and 5B are added in an adder 37, are sequentially delayed by one clock in two D-type flip flops 38 and 39 for adjusting timing, and are supplied to an absolute value circuit 40. The absolute value circuit 40 determines an absolute value of supplied data and supplies the result to one of the input terminals of an amplitude comparator 41. The above operation determines an absolute value of a value obtained by tripling error e2 of the above equation (2).

A value obtained by tripling an error tolerance value DP is inputted to the other input terminal of the amplitude comparator 41. The amplitude comparator 41 compares a tripled error e2 and a tripled error tolerance value DP. And then, a signal of "L" is outputted when error e2 is larger than an error tolerance value DP, and a signal of "H" is outputted when error e2 is at an error tolerance value DP or smaller.

Also, double differential values D3" and 2D4" inputted from the circuits of Figures 5A and 5B are added in an adder 42, are sequentially delayed by one clock in two D-type flip flops 43 and 44 for adjusting timing, and are supplied to an absolute value circuit 45. The absolute value circuit 45 determines an absolute value of supplied data and supplies the result to one of the input terminals of an amplitude comparator 46. The above operation determines an absolute value of a value obtained by tripling error e3 of the above equation (3).

A value obtained by tripling an error tolerance value DP is inputted to the other input terminal of the amplitude comparator 46. The amplitude comparator 46 compares a tripled error e2 and a tripled error tolerance value DP. And then, a signal of "L" is outputted when error e2 is larger than an error tolerance value DP, and a signal of "H" is outputted when error e2 is at an error tolerance value DP or smaller.

An "H" or "L" signal outputted from two amplitude comparators 41 and 46 is outputted as an error discrimination signal C3 via a NAND circuit 47. Thus, an error discrimination signal C3 at "L" level is outputted as a pulse signal when both of the errors e2 and e3 shown in equations (2) and (3) are within a range of an error tolerance value DP.

Moreover, Figure 6C shows a circuit for discriminating if errors between data values D2''', D3''', and D4''' on a straight line and sampled data D2, D3, and D4 are at a desired value or smaller when sampled data D1 and D5 are connected by the straight line. Namely, this circuit discriminates if errors e2, e3, and e4 of the above equations (4) to (6) are within a range of an error tolerance value DP. When all of them are within a range of an error tolerance value DP, an error discrimination signal C4 at "L" level is outputted as a pulse signal.

Besides, Figure 6D shows a circuit for discriminating if errors between data values D2'''', D3'''', D4'''', and D5'''' on a straight line and sampled data D2, D3, D4, and D5 are at a desired value or smaller when sampled data D1 and D6 are connected by the straight line. Namely, this circuit discriminates if errors e2, e3 , e4, and e5 of the above equations (7) to (10) are within a range of an error tolerance value DP. When all of them are within a range of an error tolerance value DP, an error discrimination signal C5 at "L" level is outputted as a pulse signal.

Further, Figure 6E shows a circuit for discriminating if errors between data values D2''''', D3''''', D4''''', D5''''', and D6''''' on a straight line and sampled data D2, D3, D4, D5, and D6 are at a desired value or smaller when sampled data D1 and D7 are connected by the straight line. Namely, this circuit discriminates if errors e2, e3, e4, e5, and e6 of the above equations (11) to (15) are within a range of an error tolerance value DP. When all of them are within a range of an error tolerance value DP, an error discrimination signal C6 at "L" level is outputted as a pulse signal.

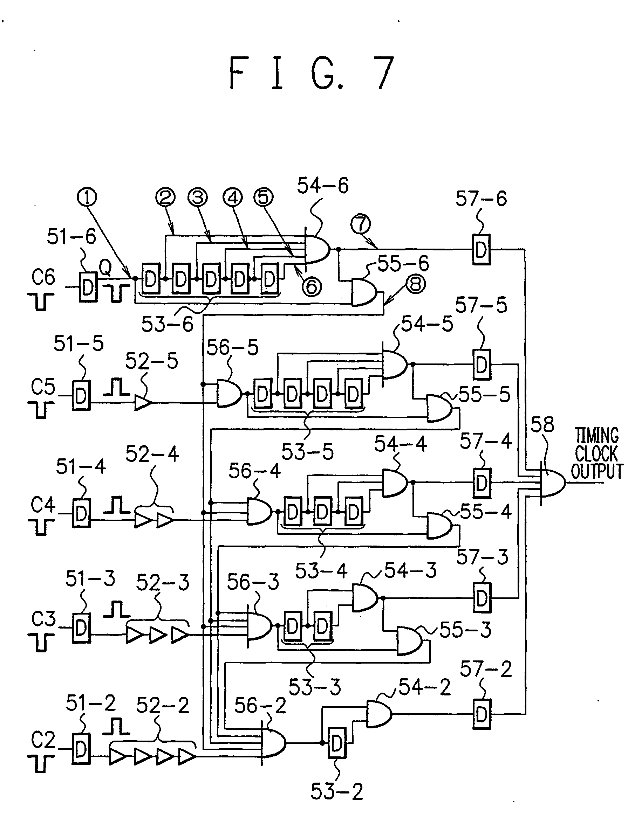

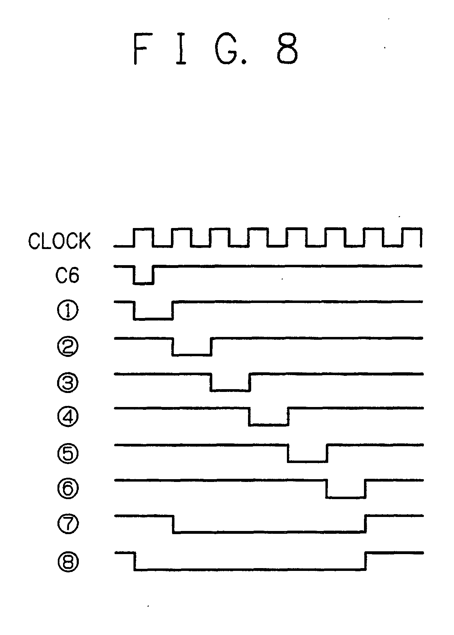

The operations of the error discriminating circuits that are shown in Figures 6A to 6E are performed in parallel, and the error discrimination signals C2 to C6 are outputted at the same timing. The error discrimination signals C2 to C6 outputted from the error discrimination circuits are subsequently inputted to a timing clock generating circuit shown in Figure 7. Figure 7 is a diagram showing an example of a circuit in which a part of the function of the sample point detecting section 2 of Figure 2 is realized by a hardware structure. Moreover, Figure 8 is a timing chart showing the operation performed in a part of the circuit shown in Figure 7. The following explanation will be made in accordance with Figures 7 and 8.

In Figure 7, error discrimination signals C2 to C6 inputted from the error discriminating circuit of Figure 6A to 6E are respectively stored in D-type flip flops 51-2 to 51-6 in a temporary manner. Among them, an error discrimination signal C6 stored in the D-type flip flop 51-6 is further delayed sequentially by one clock by five D-type flip flops 53-6. And then, signals (② to ⑥) taken from the taps on the output stages of the D-type flip flops 53-6 are inputted to an AND circuit 54-6.

The above AND circuit 54-6 ANDs the signals (② to ⑥) taken from the taps of the output stages of the D-type flip flops 53-6 so as to output a signal set at "L" level for a pulse width of five clocks as indicated by ⑦ of Figure 8. The D-type flip flops 53-6 delay an error discrimination signal C6 by five clocks because the error condition is satisfied when sampled data D1 and D7 are connected by a straight line, and because five pieces of sampled data D2, D3, D4, D5, and D6 between D1 and D7 are not necessary when sampled data D7 is detected as a sample point.

A signal (⑦) outputted from the AND circuit 54-6 is inputted to an AND circuit 55-6 and a D-type flip flop 57-6. The error discrimination signal C6 (①) outputted from the D-type flip flop 51-6 is also inputted to the AND circuit 55-6. The AND circuit 55-6 ANDs the inputted two signals (① and ⑦) and outputs the result. Hence, as shown in ⑧ of Figure 8, a signal set at "L" level for a pulse width of six clocks is outputted from the AND circuit 55-6 and is supplied to AND circuits 56-2 to 56-5, which are respectively provided on the stages for processing error discrimination signals C2 to C5.

Moreover, the error discrimination signal C5 stored in the D-type flip flop 51-5 is outputted from an inverted output terminal of the D-type flip flop 51-5, is supplied to four D-type flip flops 53-5 via a delay element 52-5, which is provided for adjusting timing, and the AND circuit 56-5, and is sequentially delayed by one clock therein. And then, signals taken from the taps on the output stages of the D-type flip flops 53-5 are inputted to an AND circuit 54-5.

The AND circuit 54-5 ANDs signals taken from the taps on the output stages of the D-type flip flops 53-5 so as to output a signal set at "L" level for a pulse width of four clocks. The D-type flip flop 53-5 delays the error discrimination signal C5 by four clocks because the error condition is satisfied when sampled data D1 and D6 are connected by a straight line, and because four pieces of sampled data D2, D3, D4, and D5 are not necessary therebetween when sampled data D6 is detected as a sample point.

A signal outputted from the AND circuit 54-5 is inputted to an AND circuit 55-5 and a D-type flip flop 57-5. The error discrimination signal C5 outputted from the D-type flip flop 51-5 is also inputted to the AND circuit 55-5. The AND circuit 55-5 ANDs the inputted two signals and outputs the signals. Hence, a signal set at "L" level for a pulse width of five clocks is outputted from the AND circuit 55-5 and is supplied to the AND circuits 56-2 to 56-4, which are respectively provided on the stages for processing the error discrimination signals C2 to C4.

The other error discrimination signals C4 to C2 are also subjected to the same operation as the error discrimination signal C5. However, delays of the D-type flip flops 53-4 to 53-2 are each shorter than delay (four clocks) of the D-type flip flop 53-5 by one clock. Further, from the AND circuits 55-4 and 55-3, signals having pulse widths of respective clocks are outputted to the AND circuits 56-3 and 56-2 provided on the lower stages.

As described above, to the AND circuits 56-2 to 56-5 provided respectively on the stages for processing the error discrimination signals C2 to C5, signals outputted from the AND circuits 55-3 to 55-6 on the upper stages are inputted. Besides, signals obtained by inversely outputting the error discrimination signals C2 to C5 in the D-type flip flops 51-2 to 51-5 are inputted to the AND circuits 56-2 to 56-5. Hence, when the AND circuits 55-3 to 55-6 on the upper stage output signals at "L" level, the error discrimination signals C2 to C5 are gated by the pulse widths in the AND circuits 56-2 to 56-5. The processing after the AND circuits 56-2 to 56-5 become invalid.

For example, on the highest stage where the error discrimination signal C6 is processed, when a signal (⑧) at "L" level is outputted with a pulse width of six clocks from the AND circuit 55-6 as described above, the gating operations of the AND circuits 56-2 to 56-5 are performed in response to the signals. The processing on the error discrimination signals C2 to C5 become invalid. Hence, a signal at "L" level with a pulse width of five clocks is outputted only from a D-type flip flop 57-6 on the highest stage, of five D-type flip flops 57-2 to 57-6 provided on side of the output stage of the timing clock generating circuit.

Signals outputted from the above five D-type flip flops 57-2 to 57-6 are inputted to an AND circuit 58. The AND circuit 58 ANDs the inputted five signals and outputs the result as a timing clock. In the above example, as a timing clock, a signal at "L" level with a pulse width of five clocks is outputted from the AND circuit 58 in response to a signal outputted from the D-type flip flop 57-6 on the highest stage.

Additionally, Figure 7 shows that the five error discrimination signals C2 to C6 are all set at "L" level (the error condition is satisfied on all straight lines connecting sampled data D1 to D7). However, the signals are not always set at "L" level. Besides, the signals may be all set at "H" level. In this case, since the gating operation is performed by the above AND circuits 56-2 to 56-5, a timing clock is outputted from the AND circuit 58. The timing clock is generated from an error discrimination signal of a longer straight line, of error discrimination signals set at "L" level.

The number of clocks that is indicated by a timing clock outputted from the AND circuit 58 is used as timing data constituting a part of compressed data. Further, sampled data is selectively extracted in synchronization with the timing clock. Thus, the extracted sampled data is used as amplitude data constituting a part of compressed data.

Figure 10 is a circuit diagram showing an example of the configuration in which hardware realizes the function of the interpolating section 13 of the expanding device shown in Figure 2.

In Figure 10, amplitude data inputted as a part of compressed data is directly inputted to a negative-side terminal of a subtracter 62 and is stored in a D-type flip flop 61 by one clock. And then, the data is inputted to a positive-side terminal of the subtracter 62. The subtracter 62 computes a difference between two successive pieces of amplitude data supplied thus.

Amplitude difference data computed by the subtracter 62 is inputted to one of the input terminals of an adder 63. Data outputted from the adder 63 is stored in a D-type flip flop 64 and is inputted to the other input terminal of the adder 63. Therefore, an integrator is constituted by the adder 63 and the D-type flip flop 64, and amplitude data is integrated. The integrating operation is performed by the number of times equal to clocks indicated by timing data, and then, an integral value of the D-type flip flop 64 is reset at 0 in response to a reset signal RST.

An integral value outputted from the D-type flip flop 64 in a clock period indicated by timing data is supplied to a divider 65. The divider 65 divides an integral value, which is supplied from the D-type flip flop 64, by a timing data value. Data outputted from the divider 65 is inputted to an adder 66. The adder 66 determines a data value for interpolating pieces of amplitude data on successive sample points by adding a data value supplied from the divider 65 and amplitude data inputted as a part of compressed data.

The above-mentioned circuits determine a data value on a sampled point between sample points by using linear interpolation on the expansion side, and the interpolation data is outputted as expansion data. As described above, it is possible to reproduce accurate expansion data, which is hardly different from original data before compression, merely by performing linear interpolation, which is an extremely simple operation.

As specifically discussed above, in the present embodiment, a sampled point, on which an error from original data is not larger than a desired value even when linear interpolation is performed in expansion, is detected as a sample point. Only a pair of amplitude data on sample points and timing data indicative of a time interval between sample points is obtained as compressed data. Thus, it is possible to remarkably improve the quality of data reproduced by expansion with high compressibility.

Particularly according to the compressing and expanding methods of the present embodiment, interpolation data between sample points generated by linear interpolation can have a smaller amplitude error as compared with original data before compression. Additionally, a phase shift can be suppressed considerably. When voice is used as data to be compressed, a phase shift seriously affects a timbre. In contrast, since the present embodiment hardly causes a phase shift, the timbre of original data can be reproduced faithfully.

Further, according to the present embodiment, an analog signal or digital data to be compressed can be directly compressed or expanded on a time base without time/frequency conversion. Hence, the operations are not complicated, and the configuration can be simplified. Moreover, when compressed data is transmitted from the compression side and is reproduced on the expansion side, inputted compressed data can be sequentially processed and reproduced by using quite a simple linear interpolating operation on a time base, thereby achieving real-time operations.

Besides, in the above embodiment, interpolation data between pieces of amplitude data on sample points is obtained by linear interpolation on the expansion side. The interpolating operation is not limited to the above example. For example, interpolation data can be obtained by curve interpolation using a predetermined sampling function. Additionally, the interpolation disclosed by the applicant in Japanese Patent Application No.11-173245 and so on is also applicable. In this case, interpolation can obtain a waveform extremely close to an analog signal. Thus , it is also possible to eliminate the need for a D/A converter and an LPF on the subsequent stage of interpolation.

Further, on the compression side as well as the expansion side, curve interpolation may be used to subsequently detect sampled points, each having an error from original data at a desired value or smaller, as a sample point when curve interpolation is performed between two pieces of sampled data included in data to be compressed. In this case, curve interpolation is preferably equal to curve interpolation performed on the expansion side.

(Embodiment 2)

Next, Embodiment 2 of the present invention will be discussed.

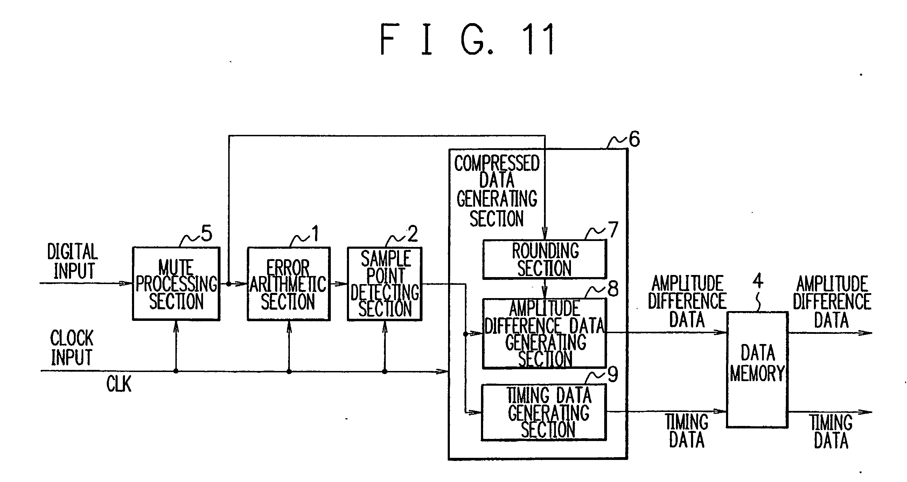

Figure 11 is a block diagram showing an example of the functional configuration of a compressing device for realizing a compressing method according to Embodiment 2. Blocks having the same function as those of Figure 2 are indicated by the same reference numerals. Like Figure 2, the compressing device of Figure 11 shows compression of a digital aural signal.

As shown in Figure 11, the compressing device of the present embodiment is provided with a mute processing section 5 on the input stage. The mute processing section 5 rounds an absolute value of sampled data to be compressed by a predetermined value (e.g., "4"). At this moment, when an absolute value of sampled data is smaller than the above predetermined value, the sampled data is regarded as a mute part. And then, a data value is replaced with "0" and is outputted. Hence, small noise components can be removed and compressibility can be further improved. An error arithmetic section 1 and a compressed data generating section 6 perform operations on data which is subjected to mute processing thus.

Furthermore, when an absolute value of sampled data to be compressed has been smaller than a first threshold value (e.g., "7") for predetermined clocks (e.g., seven clocks) or more, the sampled data may be handled as mute data. In this case, compressed data corresponding to a part handled as mute data sets a value of timing data at 0, which is not used normally, and supplies a timing data value, which is indicative of a time interval of a mute state, to amplitude data (e.g., nine bits).

In order to make recovery from a mute state, detection is made that sampled data of a second threshold value (e.g., "10") or more has continued for predetermined clocks (e.g., two clocks) or more, and recovery is made from a mute state to a normal operation.

Additionally, selection may be arbitrarily made between the case where a mute state continues only for one clock and is suspended (when only comments of a conference and the like are recorded) and the case where anine-bit mute clock continues (when music and the like is recorded).

In this manner, on the compression side, when a value of timing data is set at 0 in a mute state and a value indicative of a time interval of a mute state is supplied to amplitude data, monitoring is made on the expansion side if a value of timing data constituting compressed data is 0 or not. When the value is at 0, an expansion data value is outputted as 0 for a time interval indicated by a value of the amplitude data. In this manner, mute data having a certain time interval can be compressed to a pair of an amplitude data value and a timing data value, thereby further reducing an amount of data.

A compressed data generating section 6 of the present embodiment is provided with a rounding section 7, an amplitude difference data generating section 8, and a timing data generating section 9. Of the sections, the timing data generating section 9 generates timing data indicative of a time interval between sample points detected by the sample point detecting section 2. Since the function thereof is equal to that of Embodiment 1, the specific description thereof is omitted.

The rounding section 7 rounds a lower-order bit of data outputted from the mute processing section 5. The rounding operation can be performed by, for example, dividing output data from the mute processing section 5 by a predetermined value (e.g., 256 or 512). Such a rounding operation can shorten a data length by several bits per word, thereby largely reducing an amount of data.

Incidentally, in the present embodiment, digital data inputted to the rounding section 7 is, for example, 16-bit data, and a large data value up to 65535 can be expressed. However, in the case of voice data of an audible tone, most data of the entire data region (0 to 65535) expressed by 16 bits is concentrated on a data region around the center but hardly appears on a data region around the ends. Namely, in many cases, data actually used as voice data has a relatively large value. Even when a lower-order bit is rounded for data having such a large value, the quality of reproduced voice is hardly affected.

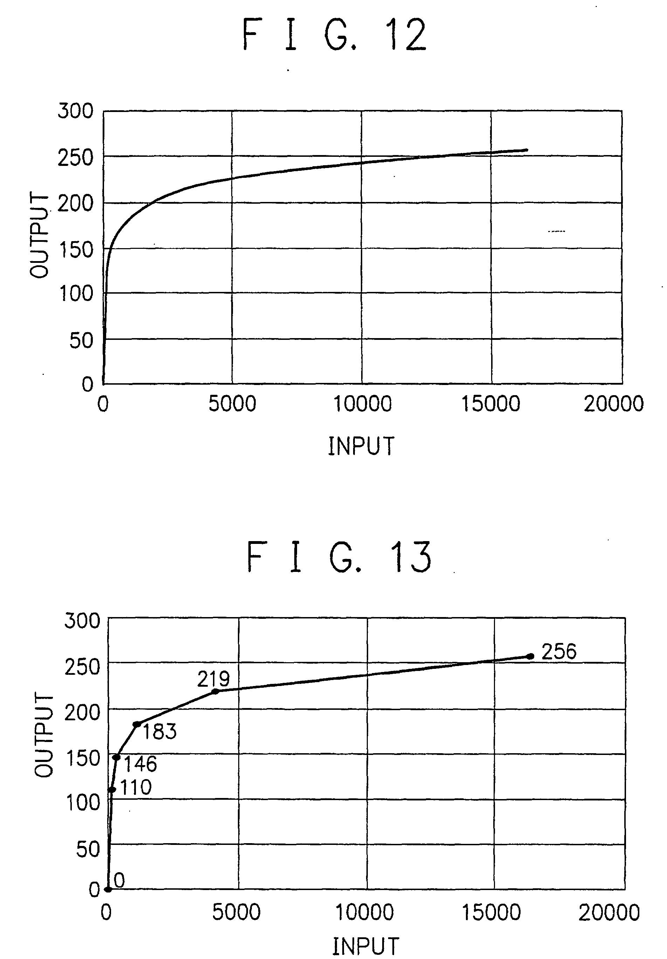

Further, as a rounding operation, instead of simply performing division by a predetermined value as described above, a data value may be rounded so as to have a nonlinear relation ship between input data and output data of the rounding section 7. Figure 12 is a diagram showing an example of a rounding operation performed in this case. In the example of Figure 12, a logarithm of a data value inputted from the mute processing section 5 is determined, and the value is used as output data of the rounding section 7.

Also, the following operation is also applicable: as shown in Figure 13, the combination of several lines makes approximation to a logarithmic curve of Figure 12, and outputted data is changed in amplitude by using the approximate function according to amplitude of data inputted from the mute processing section 5 so as to have a nonlinear relationship between an input data value and an output data value. Additionally, in the example of Figure 13, five lines are combined to make approximation to the logarithmic curve of Figure 12. If more than five lines are combined, accuracy can be further improved.

With a rounding operation according to such a nonlinear function, in the entire data region of voice data of an audible tone that is expressed by 16 bits, it is possible to concentrate output data values onto a data region around the center, on which most data appears. Hence, it is possible to lessen the influence of a rounding operation and to reduce quantization noise on a part having small amplitude, thereby further reducing the influence of a rounding operation on the quality of reproduced voice.

Besides, when a rounding operation is performed using a logarithmic function as shown in Figure 12, a bottom value of logarithm changes the quality of reproduced voice. Therefore, in the present embodiment, a bottom value of logarithm can be arbitrarily set as a parameter. Moreover, the way to handle a decimal of a logarithmic data value affects compressibility and the quality of reproduced voice. Hence, in the present embodiment, the following is set as a parameter: if a decimal data value is dropped or not to place emphasis on compressibility, the number of adopted digits of a decimal data value to place emphasis on the quality of reproduced voice, and so on.

Digital data where the rounding section 7 rounds a lower-order bit is inputted to the amplitude difference data generating section 8. The amplitude difference data generating section 8 firstly determines a discrete amplitude data value on each sample point detected by the sample point detecting section 2, and further determines a difference between amplitude data values on adjacent sample points. In the present embodiment, a pair of amplitude difference data obtained thus by the amplitude difference data generating section 8 (including an initial value of amplitude data, that is, an amplitude data value on the first sample point) and timing data obtained by the timing data generating section 9 is outputted to the data memory 4 as compressed data.

Additionally, in the example of Figure 11, a rounding operation is performed firstly on all pieces of sampled data, and amplitude data on sample points is extracted from amplitude data undergoing a rounding operation. In reverse, the following operation is also applicable: amplitude data on sample points is firstly extracted, a rounding operation is performed on extracted amplitude data, and then, a difference is determined.

Next, the following will discuss an expanding device for the compressing device of Figure 11.

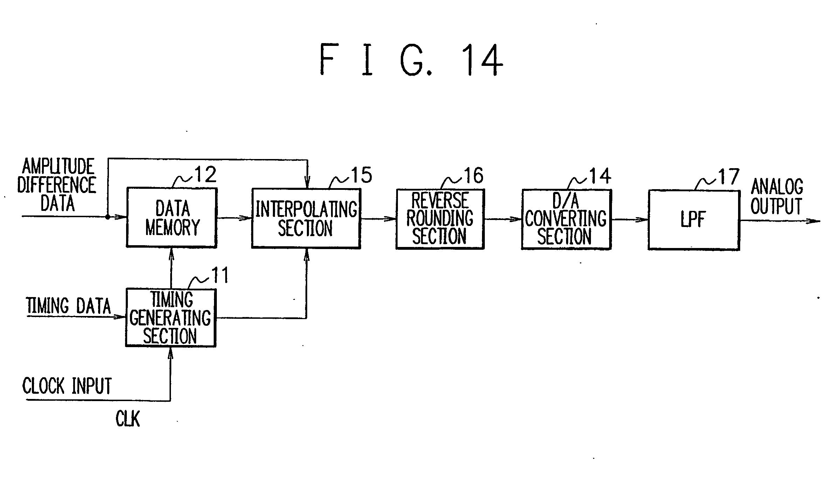

Figure 14 is a block diagram showing an example of the functional configuration of the expanding device according to the present embodiment. The blocks having the same functions as those of Figure 3 are indicated by the same reference numerals.

An interpolating section 15 of the present embodiment in Figure 14 performs a predetermined linear interpolating operation using amplitude difference data inputted from a data memory 12 and timing data inputted from a timing generating section 11 so as to generate digital interpolation data for interpolating sample points. For example, amplitude data on sample points is reproduced using initial values of amplitude difference data and amplitude data, and the same linear interpolating operation as Embodiment 1 is performed on the reproduced amplitude data. In this manner, interpolation data can be generated.

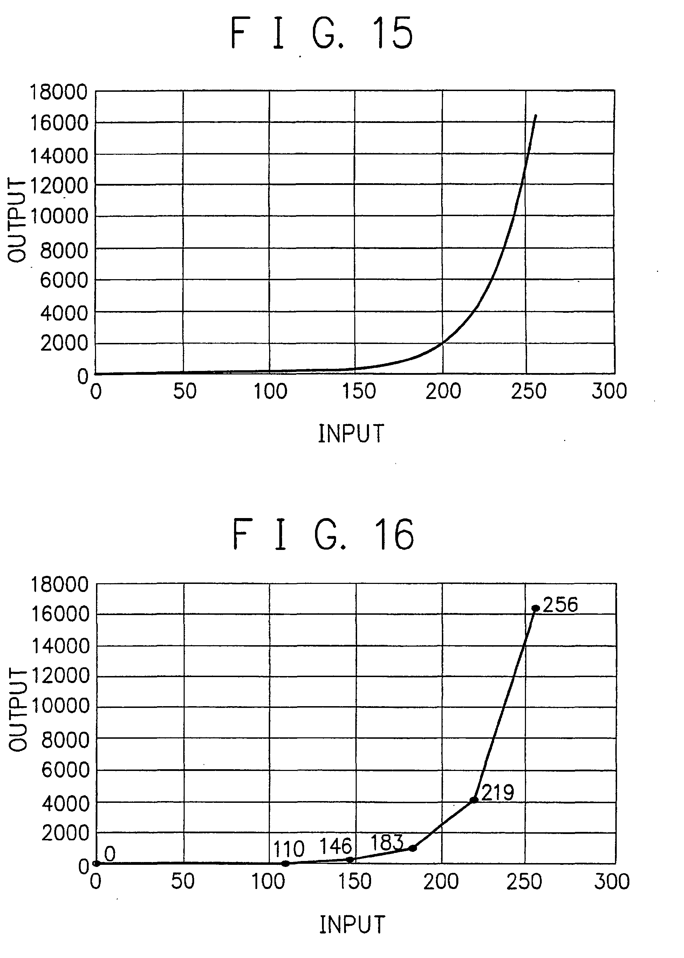

A reverse rounding section 16 performs a reverse operation of the rounding section 7 of Figure 11 on interpolation data generated by the interpolating section 15. Namely, when the rounding section 7 simply divides a data value by a predetermined value including 256 and 512, the reverse rounding section 16 multiplies interpolation data by 256 or 512. Further, when the rounding section 7 performs a nonlinear rounding operation using a logarithmic function of Figures 12 and 13 or an approximate function of the logarithmic function, a nonlinear reverse rounding operation is performed using an exponential function of Figures 15 and 16 that is reversed from the logarithmic function or using an approximate function.

Here, when a reverse rounding operation is performed using the exponential function of Figure 15, a value of an exponent can be arbitrarily set as aparameter. Moreover, as a parameter, it is possible to arbitrarily set if a decimal data value of exponential data is dropped or not, the number of adopted digits of a decimal data value, and so on. In this case, since a decimal value is dropped upon compressibility and a decimal data value is adopted upon expansion, the quality of reproduced voice can be improved while compressibility is increased.

Data on which the above reverse rounding operation is performed by the reverse rounding section 16 is subjected to D/A conversion by a D/A converter 14, and then, the data is outputted as a reproduced analog signal via a low-pass filter (LPF) 17.

According to the above description, on the expansion side, it is possible to reproduce accurate expansion data, which is hardly different from original data, merely by performing linear interpolation, which is quite a simple operation.

The compressing device and the expanding device that are configured thus according to Embodiment 2 are also constituted by a computer system including a CPU or an MPU, a ROM, and RAM. The functions of the devices are realized by operating programs stored in the above ROM, RAM; and so on.

Besides, the compressing device and the expanding device that are configured thus according to the present embodiment may be configured as hardware by combining logic circuits.

The following will discuss an example of a hardware structure of the compressing device according to the present embodiment.

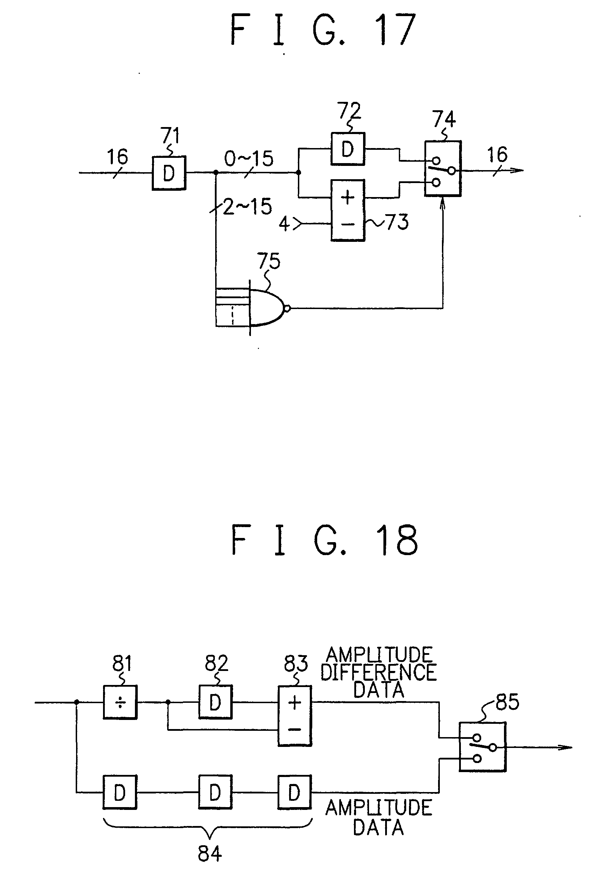

Figure 17 is a diagram showing an example of a circuit, in which hardware realizes the function of the mute processing section 5 shown in Figure 11.

In Figure 17, 16-bit sampled data inputted to be compressed is temporarily stored in a D-type flip flop 71. The 16-bit sampled data stored in the D-type flip flop 71 is supplied to a D-type flip flop 72 for adjusting timing and a subtracter 73. The subtracter 73 subtracts a predetermined value of "4" from a sampled data value supplied from the D-type flip flop 71.

A switching circuit 74 selects one of sampled data outputted from the D-type flip flop 72 and sampled data outputted from the subtracter 73 after a predetermined value is subtracted from the data, and then, the sampled data is outputted to the subsequent stage. The selecting operation is performed in response to an output signal of a NAND circuit 75.

Data values of second to fifteenth bits of sampled data stored in the D-type flip flop 71 are inputted to the NAND circuit 75. When sampled data has a value of "4" or less, values of the second to fifteenth bits are all set at "0", and a signal at "H" level is outputted from the NAND circuit 75. At this moment, the switching circuit 74 selects the output from the subtracter 73. Meanwhile, when a signal at "L" level is outputted from the NAND circuit 75, the switching circuit 74 selects the output from the D-type flip flop 72.

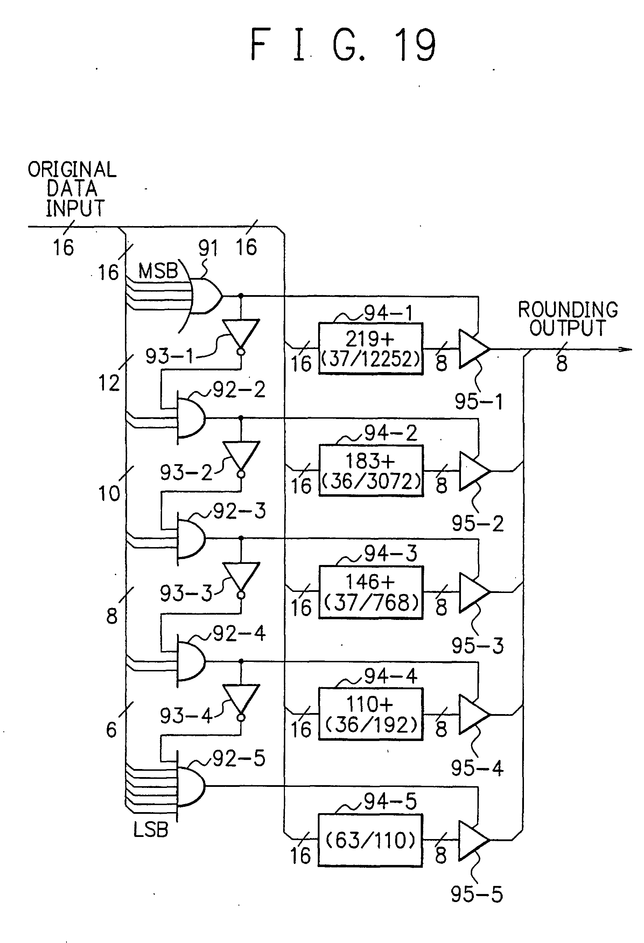

Figure 18 is a diagram showing an example of a circuit in which the functions of the rounding section 7 and the amplitude difference data generating section 8 shown in Figure 17 are realized by hardware.

In Figure 18, from sampled data outputted from the mute processing circuit of Figure 17, only sampled data on sample points detected by the circuits of Figures 4 to 7 is extracted and is inputted to a dividing circuit 81. The dividing circuit 81 divides inputted sampled data by a predetermined value such as 256 and 512 so as to round a lower-order bit of sampled data.

Sampled data rounded by the dividing circuit 81 is directly supplied to the negative-side terminal of a subtracter 83 and is delayed by one clock in a D-type flip flop 82. And then, the data is supplied to the positive-side terminal of the subtracter 83. The subtracter 83 subtracts current sampled data from sampled data delayed by one clock in the D-type flip flop 82. Thus, amplitude difference data is generated.

Amplitude difference data generated thus is inputted to one of the input terminals of a switching circuit 85. Sampled data on sample points that is outputted from the mute processing circuit of Figure 17 is inputted to the other input terminal of the switching circuit 85 via a plurality of D-type flip flops 84 provided for adjusting timing. In the first clock for compression, sampled data inputted from the D-type flip flop 84 is selected by the switching circuit 85 as an initial value of amplitude data. Thereafter, amplitude difference data inputted from the subtracter 83 is selected by the switching circuit 85 and is outputted.

Additionally, in the example of Figure 18, a rounding operation is linearly performed simply by dividing a sampled data value by a predetermined value. For example, a rounding operation may be performed by the nonlinear operation shown in Figure 12 or 13. In this case, a logarithmic circuit is provided instead of the divider 81.

Figure 19 is a diagram showing an example of a circuit for performing a nonlinear rounding operation of Figure 13. In Figure 19, from inputted 16-bit sampled data, four bits from the top are inputted to an OR circuit 91, the subsequent two bits are inputted to an AND circuit 92-2, the subsequent two bits are inputted to an AND circuit 92-3, the subsequent two bits are inputted to an AND circuit 92-4, and the last six bits are inputted to an AND circuit 92-5. With this configuration, according to an inputted sampled data value, a signal at "H" level is outputted from a circuit of the OR circuit 91 and AND circuits 92-2 to 92-5 that satisfies a logic condition. Therefore, a range of an inputted sampled data value is determined from the five lines shown in Figure 13.

Signals at "H" level or "L" level that are outputted from the OR circuit 91 and the AND circuits 92-2 to 92-5 are respectively inputted to the control terminals of gate circuits 95-1 to 95-5. The gate circuits 95-1 to 95-5 output the results of arithmetic circuits 94-1 to 94-5, which are provided on the previous stages, as rounding results when signals at "H" level are supplied to the control terminals of the gate circuits 95-1 to 95-5. The five arithmetic circuits 94-1 to 94-5 perform predetermined operations (see Figure 19) on inputted sampled data so as to respectively compute data values on the five lines of Figure 13.

Signals at "H" level or "L" level that are outputted from the OR circuit 91 and the AND circuits 92-2 to 92-4 are respectively inputted to the AND circuits 92-2 to 92-5 via inverters 93-1 to 93-4. Thus, when any one of the OR circuit 91 and the AND circuits 92-2 to 92-4 outputs a signal at "H" level, the AND circuits 92-2 to 92-5 on the side of a lower-order bit always output a signal at "L" level to the gate circuits 95-2 to 95-5 and prohibit the output from the corresponding arithmetic circuits 94-2 to 94-5.

In this manner, a data value on any one of the lines of Figure 13 is determined according to an inputted sampled data value, and 16-bit sampled data is rounded to eight bits. And then, the rounded sampled data is outputted as amplitude data on a sample point.

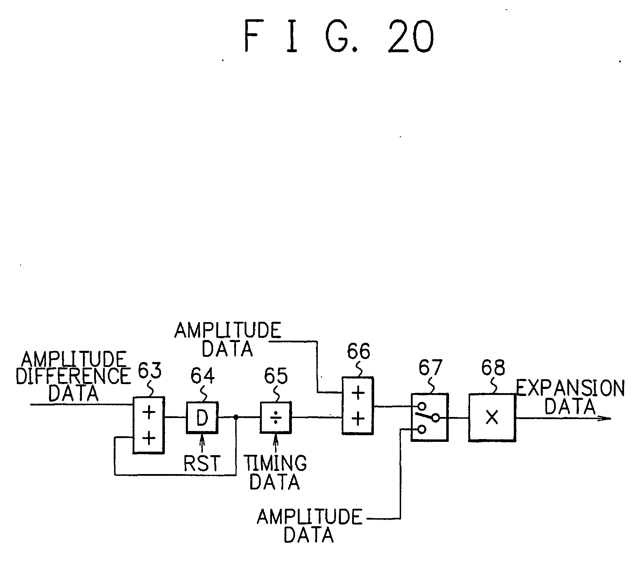

Figure 20 is a diagram showing an example of the configuration of a circuit in which hardware realizes the functions of the interpolating section 15 and the reverse rounding section 16 of the expanding device shown in Figure 14. Additionally, in Figure 20, apart having the same function as the expanding device of Embodiment 1 of Figure 1 is indicated by the same reference numeral.

In the case of the expanding device of Embodiment 2 shown in Figure 20, a difference of amplitude data has already been determined in the compressing device. Thus, the D-type flip flop 61 and the subtracter 62 of Figure 10 are not necessary. Namely, amplitude difference data inputted as a part of compressed data is directly integrated by an adder 63 and a D-type flip flop 64, and an integral value is outputted to a divider 65.

And then, in the divider 65, an integral value supplied from the D-type flip flop 64 is divided by a timing data value. Data of the division result and amplitude data, which is inputted as a part of compressed data, are added by an adder 66. Hence, data values are determined for interpolating pieces of amplitude data on successive sample points.

Data outputted from the adder 66 is inputted to one of the input terminals of a switching circuit 67. An initial value of amplitude data supplied as compressed data is inputted to the other input terminal of the switching circuit 67. In the first clock of expansion, an initial value of amplitude data is selected by the switching circuit 67. Thereafter, amplitude data inputted from the adder 66 is selected by the switching circuit 67 and is outputted.

Data outputted from the switching circuit 67 is multiplied by a multiplier 68 by a value equal to a value divided in the divider 81 of the compressing device of Figure 18 (e.g., 256 or 512 times). Here, on the compression side, for example, when a rounding operation is performed by the nonlinear operation of Figures 12 and 13, an exponential circuit for realizing the exponential function of Figure 15 or 16 is provided instead of the multiplier 68.

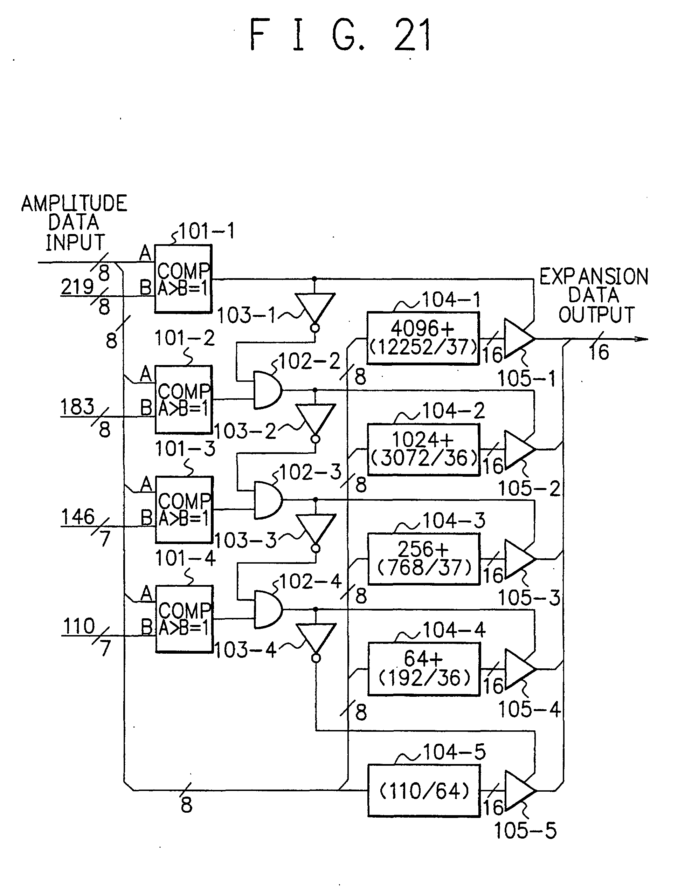

Figure 21 is a diagram showing an example of a circuit for performing the nonlinear reverse rounding operation of Figure 16. In Figure 21, inputted eight-bit amplitude data is inputted to four amplitude comparators 101-1 to 101-4. The amplitude comparators 101-1 to 101-4 compare inputted amplitude data values and values on junctions of the lines shown in Figure 16, and output signals at "H" level when an amplitude data value is larger. With this configuration, according to a value of inputted amplitude data, a signal at "H" level is outputted from a part of the four amplitude comparators 101-1 to 101-4 that satisfies the condition. Hence, a range of an inputted amplitude data value is determined from the five lines of Figure 16.

A signal at "H" level or "L" level that is outputted from the amplitude comparator 101-1 is inputted to the control terminal of a gate circuit 105-1. Moreover, signals at "H" level or "L" level that are outputted from the amplitude comparators 101-2 to 101-4 are respectively inputted to the control terminals of gate circuits 105-2 to 105-4 via AND circuits 102-2 to 102-4. A signal at "H" or "L" level that is outputted from the amplitude comparator 101-4 and passes through the AND circuit 102-4 is also inputted to the control terminal of a gate circuit 105-5 via an inverter 103-4.

The gate circuits 105-1 to 105-5 output the results of reverse rounding performed in arithmetic circuits 104-1 to 104-5, which are provided on the previous stages, as expansion data when a signal at "H" level is supplied to the control terminals of the gate circuits 105-1 to 105-5. The five arithmetic circuits 104-1 to 104-5 perform predetermined operations (see Figure 21) on inputted amplitude data so as to respectively compute data values on the five lines of Figure 16.

Further, signals at "H" or "L" level that are outputted from the AND circuits 102-1 to 102-3 are respectively inputted to the AND circuits 102-2 to 102-4 via inverters 103-1 to 103-3. Hence, when any one of the amplitude comparators 101-2 to 101-4 outputs a signal at "H" level, the AND circuits 102-2 to 102-4 on the lower-order side always output signals at "L" level to the gate circuits 105-2 to 105-4 and prohibit the output from the corresponding arithmetic circuits 104-2 to 104-4. Here, when any of the amplitude comparators 101-2 to 101-4 does not output a signal at "H" level, the arithmetic result of the arithmetic circuit 104-5 is outputted.

In this manner, according to a value of inputted amplitude data, a data value on any of the lines shown in Figure 16 is determined and eight-bit amplitude data is turned back to 16-bit amplitude data. And then, the data subjected to a reverse rounding operation is outputted as expansion data.

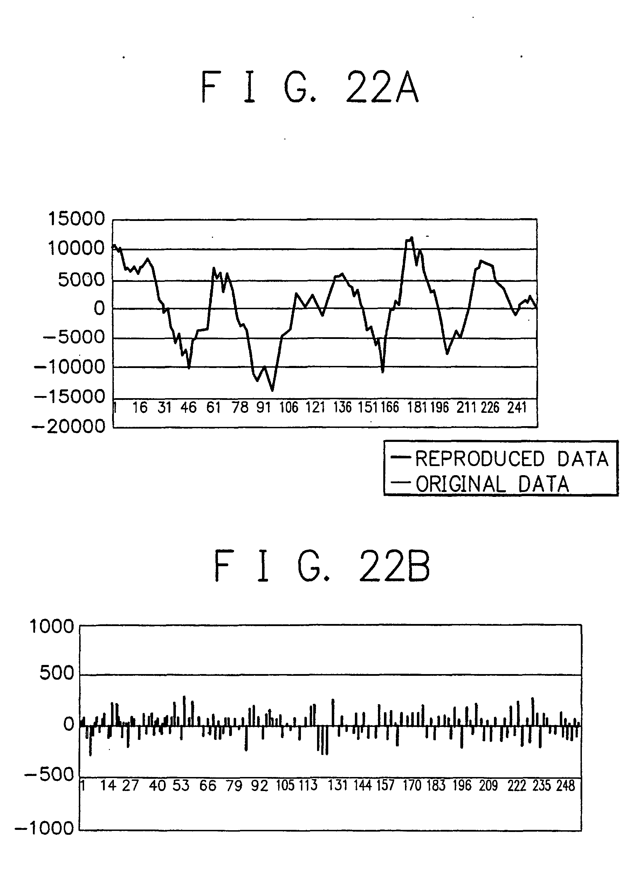

Figure 22A and 22B are diagrams for comparing original data before compression and data reproduced by expansion according to Embodiment 2. Here, Figures 22A and 22B show an example in which an error tolerance value is set at 256. Figure 22A is a diagram showing waveforms of original data before compression and data reproduced by expansion. As shown in Figure 22A, the waveforms of original data and reproduced data substantially conform to each other. Figure 22B is a diagram showing differences between original data and reproduced data. As shown in Figure 22B, a difference of data is at an error tolerance value of 256 or smaller at the maximum.

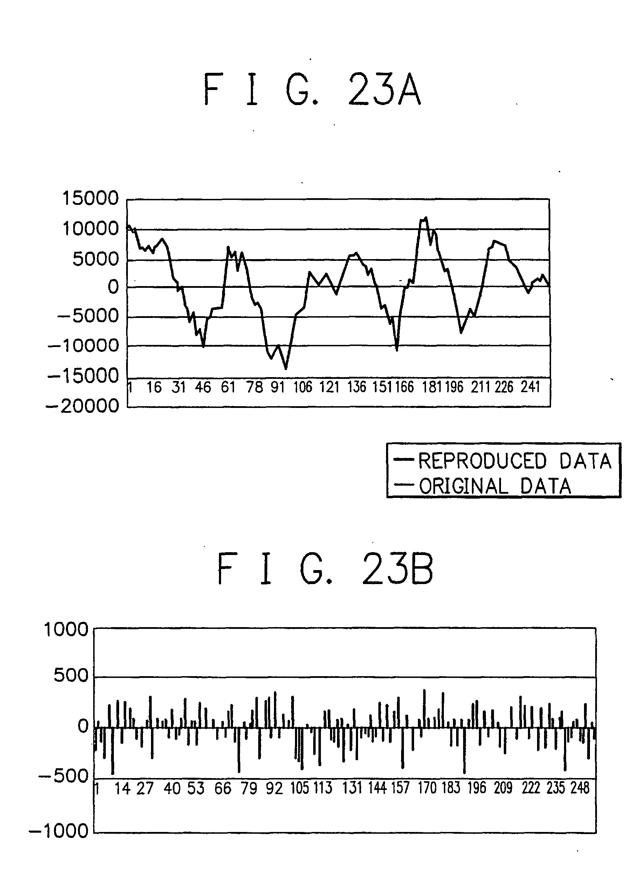

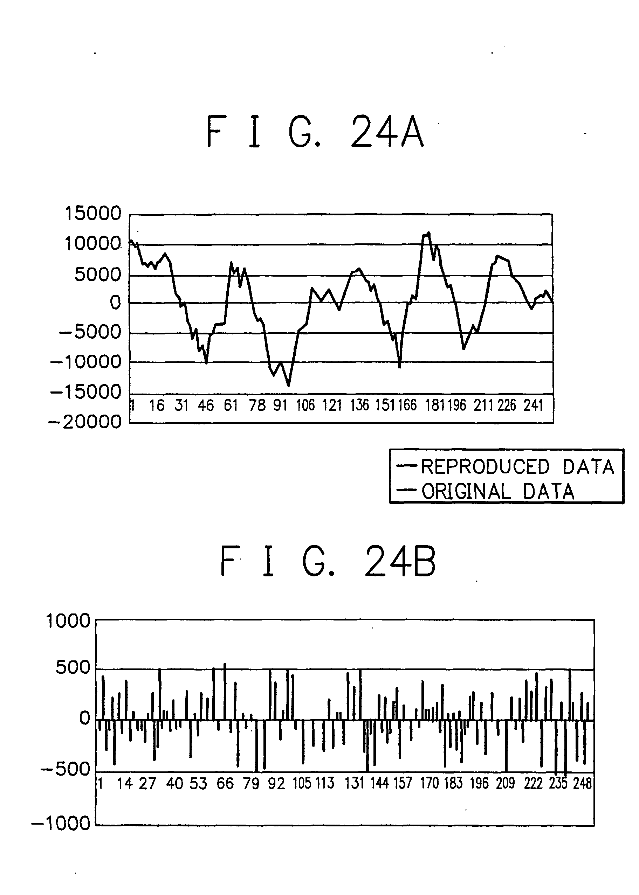

Moreover, Figures 23A, 23B, 24A and 24B show comparison examples of original data before compression and reproduced data when error tolerance values are set at 384 and 512. As shown in Figures 23 and 24, a difference between original data and reproduced data is an error tolerance value of 384 and 512 at the maximum, and original data and reproduced data substantially conform to each other. In this manner, compressibility can be further improved by increasing an error tolerance value, and the quality of reproduced data can be maintained with high accuracy.

As specifically described above, according to Embodiment 2, it is possible to realize both of high compressibility and the improved quality of reproduced data like Embodiment 1. Particularly since a phase shift hardly occurs between reproduced data and original data, the timbre of original data can be reproduced faithfully. Further, according to the present embodiment, data to be compressed can be compressed and expanded directly on a time base. Thus, the processing is not complicated and the configuration can be simplified. Particularly, since original data can be decompressed by quite a simple linear interpolating operation on the expansion side, real-time operations can be realized.

Additionally, in the present embodiment, since a lower-order bit is rounded on the compression side, a data length can be shortened by several bits per word. Hence, it is possible to largely reduce an amount of data. At this moment, most of amplitude data to be rounded concentrates on a data region around the center of the entire data region but hardly appears on a data region around the ends. Thus, a reduction in a lower-order bit does not affect the quality of reproduced voice on the expansion side.

Besides, in the present embodiment, the rounding operation is performed so as to have a nonlinear relationship between a data value before the rounding operation and a data value after the rounding operation. Therefore, in the entire data region indicative of voice data of an audible tone, output data values can be concentrated onto a data region around the center where most data appears, and the influence of the rounding operation can be reduced, thereby further reducing the influence on the quality of reproduced voice on the expansion side.

Furthermore, in the present embodiment, instead of using rounded amplitude data on sample points as compressed data, difference data is further obtained as compressed data. Thus, it is possible to further reduce the number of bits required for compressed data, thereby further reducing an amount of data. Therefore, higher compressibility can be achieved while the extremely high quality of reproduced data is maintained.

Besides, in Embodiment 2 as well, on the expansion side, interpolation data between pieces of amplitude data on sample points is obtained by linear interpolation. The interpolating operation is not limited to the above example. For example, interpolation data may be determined by curve interpolation using a predetermined sampling function. Moreover, the interpolation of Japanese Patent Application No.11-173245, which has been previously applied by the applicant, may be performed.

Further, the following operation is also applicable: in addition to the expansion side, curve interpolation is performed on the compression side as well, and when curve interpolation is performed between two pieces of sampled data included in data to be compressed, sampled points where errors from original data are at a predetermined value or smaller are sequentially detected as sample points. In this case, curve interpolation is preferably equal to that on the expansion side.

Also, in Embodiment 2, when a rounding operation is performed in a nonlinear manner, data values before and after the rounding operation have a relationship of a logarithmic function. A function other than a logarithmic function is also applicable as long as the relationship places emphasis on a part of a data region.

Additionally, in Embodiments 1 and 2, timing data has three bits and a straight line is drawn within six clocks from reference sampled data to discriminate an error. The present invention is not limited to the above example. For example, a predetermined range for error discrimination may be set at seven clocks. Moreover, the number of bits of timing data may be set at 4 or more, and a predetermined range may be set at eight clocks or more when error discrimination is made by drawing a straight line from reference sampled data. Thus, compressibility can be further improved. Further, the number of bits of timing data or a predetermined range for error discrimination may be arbitrarily set as a parameter.

Furthermore, in the above embodiments, successive values are used as a time interval between two pieces of sampled data when error discrimination is performed for detecting sample points. For example, when error discrimination is performed within a maximum range of 16 clocks (the number of bits of timing data is 5), a timing data value is selected from 2, 3, 4, 5, 6, 7, 8, 9, 10, 11, 12, 13, 14, 15, and 16 as a time interval from reference sampled data.

In contrast, discontiguous timing data values may be used as time intervals in a range wider than a predetermined interval. For example, when error discrimination is performed within a maximum range of 16 clocks, timing data values of 2, 3, 4, 5, 6, 7, 8, 9, 10, 12, 14, 16, 18, 20, and 24 may be adopted as time intervals from reference sampled data.

In this case, without increasing the number of times of error discrimination for detecting a single sample point, it is possible to increase a maximum width for a time interval between two pieces of sampled data. Hence, on a part where amplitude is not largely changed, for example, on a mute part, without delay in discriminating time, it is possible to maximize an interval between sample points and to minimize the number of sample points, thereby further improving compressibility.

Further, time intervals between two pieces of sampled data is continuous in a range shorter than a predetermined interval (time interval at "10" or less). Hence, an error can be discriminated more accurately on the part. A range smaller than the predetermined interval has many of time intervals between reference sampled point and a sampled point on which an error exceeds a desired value. When used time intervals are discrete in a range where the error condition is frequently satisfied, sample points may increase in number.

For example, when timing data values of 2, 4, 6, ..., are adopted as time intervals from reference sampled data, even if a maximum time interval for satisfying the error condition is originally five clocks, error discrimination is not performed on the five clocks. Hence, four clocks are actually adopted as a time interval. If such a case occurs frequently, the number of detected sample points increases accordingly. However, when time intervals are continuous in a range smaller than the predetermined time interval, it is possible to minimize the number of detected sample points.

Besides, in the above embodiments, error discrimination for detecting sample points is limited to a range of predetermined clocks from a reference sampled point. The present invention is not limited to the above example. For example, the operation is performed without limiting a time interval between two pieces of data within a predetermined range. The two pieces of data are selected for detecting discrete sample points. And then, a sampled point may be sequentially detected as a sample point just before a sampled point where an error exceeds a desired value. In this case, it is possible to further reduce the number of sample points, thereby further improving compressibility.

Additionally, in the above embodiments, a tolerance value of error is set at 256, 384, and 512. The value is limited to the above. A smaller tolerance value of error can realize compression and expansion to place emphasis on reproducibility of a reproduced analog signal. Further, a larger tolerance value of error can realize compression and expansion to place emphasis on compressibility. Such an error tolerance value may be arbitrarily set as a parameter.

Besides, the following operation is also applicable: an error tolerance value is used as a function of data amplitude, an error tolerance value is increased on, for example, a part having large amplitude, and an error tolerance value is decreased at a part having small amplitude. On a part having large amplitude, even when an error increases to a degree, the error is not large enough to affect sound quality. Therefore, when an error tolerance value is dynamically changed thus as a function of data amplitude, compressibility can be further increased while extremely good sound quality is maintained.

Additionally, the following operation is also applicable: an error tolerance value is used as a frequency function, an error tolerance value is increased on, for example, a part having a high frequency, and an error tolerance value is decreased on a part having a low frequency. On a part having ahigh frequency in a series of signals inputted to be compressed, that is, on a part where a sampled data value has a relatively large change on an adjacent sampling point as well, a small error tolerance value increases the number of detected sample points and high compressibility may not be achieved. However, by dynamically increasing an error tolerance value on a part having a high frequency, compressibility can be further improved while good sound quality of reproduced data is maintained entirely.

Surely an error tolerance value may be dynamically changed as functions of data amplitude and frequency.

The above-mentioned compressing and expanding methods of Embodiments 1 and 2 can be realized by any of hardware, DSP, and software. For example, in the case of software, the compressing device and the expanding device of the present embodiments are actually composed of a CPU or MPU, RAM, ROM, and so on of acomputer, and the methods are realized by operating programs stored in RAM and ROM.

Therefore, the methods are realized as follows: programs for operating a computer for achieving the function of the present embodiments are stored in a recording medium such as a CD-ROM, and the programs are read by the computer. As a recording medium for recording such programs, a floppy disk, a hard disk, a magnetic tape, an optical disk, a magneto-optical disk, a DVD, a nonvolatile memory card, and so on are applicable in addition to a CD-ROM. Also, the above programs may be downloaded to the computer via a network such as the Internet.

Further, in addition to the case where the computer runs supplied programs to achieve the function of the above embodiments, the embodiments of the present invention also include the programs used in the case where the programs realize the function of the above embodiments in coordination with OS (operating system), which operates in the computer, or other application software and the like, and the case where all or some of the operations of the supplied programs are performed by a function extended board and a function extended unit of the computer to achieve the function of the above embodiments.

Additionally, each of the above-mentioned embodiments merely shows an example of the present invention. It should be understood that there is no intention to limit the invention to the specific forms disclosed. Namely, the present invention is to cover various forms within the spirit or major characteristics of the invention.

As specifically described in the above embodiments, according to the present invention, with the simple configuration, it is possible to provide new compressing and expanding methods for achieving high compressibility and the improved quality of reproduced data with short compressing and expanding time.

Namely, according to the present invention, from many pieces of sampled data included in data to be compressed, only a pair of amplitude data on a sample point and timing data indicative of a time interval between sample points is obtained as compressed data. On the sample point, an error from original data is not large even when interpolation is performed during expansion. Therefore, it is possible to remarkably improve the quality of data reproduced by expansion while achieving high compressibility.

Further, according to the present invention, when a signal is compressed and expanded on a time base, the operation can be performed on a time base without frequency conversion. Compression and expansion can be simplified to shorten the operating time and the configuration for the operations can be simplified. Moreover, when compressed data is transmitted from the compression side and is reproduced on the expansion side as well, a simple interpolating operation on a time base can sequentially process and reproduce compressed data inputted to the expansion side, thereby achieving real-time operations.

According to another characteristic of the present invention, a linear interpolating operation is performed as an interpolating operation. Thus, compression and expansion can be performed merely by a linear interpolating operation, which is particularly simple among interpolating operations, resulting in faster compression and expansion.

According to another characteristic of the present invention, on the compression side, a sampled point having a maximum time interval between two pieces of sampled data in a predetermined range is sequentially detected as a sample point of compressed data. Hence, individual timing data values can be contained within predetermined bits, the number of detected sample points can be minimized, and compressibility can be improved accordingly.

According to another characteristic of the present invention, a sampled point just before a sampled point where an error exceeds a desired value is sequentially detected as a sample point of compressed data. Thus, an interval between sample points can be maximized and the number of detected sample points can be minimized, thereby achieving higher compressibility.

According to another characteristic of the present invention, time intervals between the two pieces of sampled data are discontiguous in a wider range than a predetermined interval. The two pieces of sampled data are used in error discrimination for detecting a sample point. Therefore, without delay in discriminating time, an interval between sample points can be maximized and the number of detected sample points can be minimized, thereby achieving high compressibility. Further, in a range smaller than a predetermined interval where the error condition is frequently satisfied, error discrimination can be performed with accuracy and the number of detected sample points can be minimized.

According to another characteristic of the present invention, a tolerance value of error is dynamically changed as a function of amplitude or frequency of data to be compressed. Hence, on a part where a relatively large error is not visible, an interval between sample points can be maximized and the number of detected sample points can be minimized. On a part where an error is relatively visible, an increase in error can be prevented. Hence, it is possible to further improve compressibility while maintaining good quality of expansion data.

According to another characteristic of the present invention, since a lower-order bit is rounded, a data length of amplitude data on sample points can be reduced by several bits per word, thereby achieving high compressibility. At this moment, digital data to be rounded is concentrated onto a part of the entire data region expressed by the number of bits but hardly appears on a data region of the rounded lower-order bit. Thus, it is also possible to suppress degradation in quality of data reproduced on the expansion side.

Further, according to another characteristic of the present invention, instead of using amplitude data on detected sample points as compressed data, difference data is further obtained as compressed data. Hence, the number of bits required for compressed data can be further reduced, thereby achieving higher compressibility.

Furthermore, according to another characteristic of the present invention, on the compression side, a value of timing data is set at 0 regarding compressed data on a part of zero data, and a value indicative of a time interval of zero data is supplied to amplitude data. On the expansion side, when timing data constituting compressed data has a value of 0, a value of expansion data is set at 0 for a time interval indicated by avalue of amplitude data. Hence, zero data having a time interval is compressed to a pair of amplitude data and timing data to further reduce an amount of data, thereby achieving higher compressibility.

[Industrial Applicability]

The present invention is useful for providing new compressing and expanding methods capable of realizing both of a high compressibility and improved quality of reproduced data with a simple configuration and in a shorter compressing and expanding time.

**Claims**

1. A compressing method **characterized in that** as a sample point, a sampled point is detected where an error from original data is at a desired value or smaller when linear interpolation is performed on two pieces of sampled data included in data to be compressed, and a pair of amplitude data on each sample point and timing data indicative of a time interval between sample points is obtained as compressed data.

2. A compressing method **characterized in that** data to be compressed is sampled at a time interval of a sampled point where an error is at a desired value or smaller between a data value on a straight line for connecting two pieces of sampled data included in said data to be compressed and a sampled data value on the same sampled point as the data value on the straight line, and a pair of discrete amplitude data on each sample point and timing data indicative of a time interval between sample points is obtained as compressed data.

3. A compressing method **characterized in that** regarding time intervals on sampled points where errors are all at a desired value or smaller between data values on a straight line for connecting two pieces of sampled data included in data to be compressed and sampled data values on the same sampled points as the data values on the straight line, said data to be compressed is sampled at a time interval of a sampled point having a maximum time interval between the two pieces of sampled data in a predetermined range, and a pair of discrete amplitude data on each sample point and timing data indicative of a time interval between sample points is obtained as compressed data.

4. A compressing method **characterized in that** regarding sampled points where errors are all at a desired value or smaller between data values on a straight line for connecting two pieces of sampled data included in data to be compressed and sampled data values on the same sampled points as the data values on the straight line, a sampled point just before a sampled point where said error exceeds said desired value is sequentially detected as a sample point, and a pair of discrete amplitude data on each sample point and timing data indicative of a time interval between sample points is obtained as compressed data.

5. The compressing method according to claim 2, **characterized in that** an error is computed by a double differential value of sampled data between a data value on the straight line for connecting two pieces of sampled data included in said data to be compressed and a sampled data value on the same sampled point as the data value on the straight line.

6. The compressing method according to claim 3, **characterized by** setting as a parameter a predetermined range of a time interval between said two pieces of sampled data.

7. The compressing method according to claim 3, **characterized in that** a time interval between said two pieces of sampled data adopted in error discrimination for detecting said sample point is discontiguous in a range wider than a predetermined interval.

8. The compressing method according to claim 1, **characterized by** setting said error tolerance value as a parameter.

9. The compressing method according to claim 1, **characterized in that** said error tolerance value is dynamically changed as a function of at least one of amplitude and frequency of said data to be compressed.

10. The compressing method according to claim 1, **characterized in that** sampled data having an absolute value smaller than a predetermined value is replaced with zero data, in said data to be compressed.

11. The compressing method according to claim 1, **characterized in that** an absolute value of said data to be compressed is rounded by a predetermined value, and mute processing is performed, in which sampled data having an absolute value smaller than said predetermined value is replaced with zero data.

12. The compressing method according to claim 10, **characterized in that** compressed data on said zero data sets a value of timing data at 0 and supplies a value indicative of a time interval of said zero data to amplitude data.

13. The compressing method according to claim 1, **characterized in that** a rounding operation is performed on a lower-order bit of said data to be compressed or said amplitude data on each sample point, and a pair of said rounded amplitude data on each sample point and timing data indicative of a time interval between sample points is obtained as compressed data.

14. The compressing method according to claim 13, **characterized in that** said rounding operation is performed by an operation having a nonlinear relationship between data values before and after said rounding operation.

15. The compressing method according to claim 14, **characterized in that** said operation having a nonlinear relationship is based on a logarithmic function or an approximate function.

16. The compressing method according to claim 15, **characterized by** setting a bottom of said logarithm as a parameter.

17. The compressing method according to claim 1, **characterized in that** a pair of amplitude difference data, which is obtained by determining difference between pieces of said amplitude data on sample points, and timing data, which is indicative of a time interval between sample points, is obtained as compressed data.

18. A compressing method, **characterized by** comprising the steps of:

   detecting a sampled point, on which an error from original data is at a desired value or smaller when interpolation is performed on two pieces of sampled data included in data to be compressed, as a sample point, and generating compressed data by using sampled data on said detected sample points.

19. A compressing device, comprising:

   sample point detecting means for detecting a sampled point, on which an error is at a desired value or smaller between a data value on a straight line for connecting two pieces of sampled data included in data to be compressed and a sampled data value on the same sampled point as the data value on the straights line, as a sample point, and
   compressed data generating means for obtaining as compressed data a pair of discrete amplitude data on each sample point detected by said sample point detecting means and timing data indicative of a time interval between sample points.

20. A compressing device, comprising:

sample point detectingmeans for detecting a sampled point having a maximum time interval between two pieces of sampled data within a predetermined range, as a sample point regarding sampled points where errors are all at a desired value or smaller between data values on a straight line for connecting said two pieces of sampled data included in data to be compressed and sampled data values on the same sampled points as the data values on the straight line, and
compressed data generating means for obtaining as compressed data a pair of discrete amplitude data on each sample point detected by said sample point detecting means and timing data indicative of a time interval between sample points.

21. A compressing device, comprising:

sample point detecting means for detecting as a sample point a sampled point just before a sampled point where an error exceeds a desired value, regarding sampled points where said errors are all at said desired value or smaller between data values on a straight line for connecting said two pieces of sampled data included in data to be compressed and sampled data values on the same sampled points as the data values on the straight line, and
compressed data generating means for obtaining as compressed data a pair of discrete amplitude data on each sample point detected by said sample point detecting means and timing data indicative of a time interval between sample points.

22. The compressing device according to claim 19, **characterized in that** an error between a data value on a straight line for connecting two pieces of sampled data included in data to be compressed and a sampled data value on the same sampled point as the data value on the straight line is determined by a double differential value of sampled data.

23. The compressing device according to claim 20, further comprising predetermined range setting means for setting as a parameter a predetermined range of a time interval between said two pieces of sampled data.

24. The compressing device according to claim 20, **characterized in that** said sample point detecting means uses time intervals being discontiguous in a range wider than a predetermined interval, as a time interval between said two pieces of sampled data used upon error discrimination for detecting said sample point, and said sample point detecting means performs said error discrimination.

25. The compressing device according to claim 19, further comprising error tolerance value setting means for setting said error tolerance value as a parameter.

26. The compressing device according to claim 19, further comprising:

detecting means for detecting at least one of amplitude and frequency of data to be compressed, and
error tolerance value changing means for dynamically changing said error tolerance value according to at least one of said amplitude and frequency that are detected by said detecting means.

27. The compressing device according to claim 19, further comprising mute processing means for replacing sampled data having an absolute value smaller than a predetermined value with zero data, in said data to be compressed.

28. The compressing device according to claim 19, further comprising mute processing means for rounding an absolute value of said data to be compressed by a predetermined value, and replacing sampled data having an absolute value smaller than said predetermined value with zero data.

29. The compressing device according to claim 27, **characterized in that** said compressed data generating means sets a value of timing data at 0 regarding compressed data on said zero data, and supplies a value indicative of a time interval of said zero data to amplitude data.

30. The compressing device according to claim 19, **characterized in that** said compressed data generating means includes rounding means for rounding a lower-order bit of amplitude data on said data to be compressed or said amplitude data on each sample point, and

**characterized in that** a pair of amplitude data on said rounded sample point and timing data indicative of a time interval between sample points is obtained as compressed data.

31. The compressing device according to claim 30, **characterized in that** said rounding operation is performed by an operation having a nonlinear relationship between data values before and after said rounding operation.

32. The compressing device according to claim 31, **characterized in that** said operation having a nonlinear relationship is based on a logarithmic function or an approximate function.

33. The compressing device according to claim 32, further comprising bottom setting means for setting a bottom of said logarithm as a parameter.

34. The compressing device according to claim 19, **characterized in that** said compressed data generating means includes difference computing means for computing difference between pieces of amplitude data on said sample points, and
**characterized in that** a pair of amplitude difference data determined by said difference computing means and timing data indicative of a time interval between sample points is obtained as compressed data.

35. A compressing device, comprising:

sample point detecting means for detecting a sampled point, on which an error from original data is at a desired value or smaller when interpolation is performed on two pieces sampled data included in data to be compressed, as a sample point, and
compressed data generating means for generating compressed data by using sampled data on each sample point detected by said sample point detecting means.

36. An expanding method **characterized by** obtaining expansion data by determining interpolation data for interpolating pieces of amplitude data having a time interval indicated by timing data, by using amplitude data on each sample point and timing data between sample points, regarding compressed data having a pair of amplitude data on a predetermined sample point that is extracted from data to be compressed and timing data indicative of a time interval between sample points.

37. An expanding method **characterized by** obtaining expansion data by determining interpolation data for interpolating pieces of amplitude data having a time interval indicated by timing data, by using difference data, which is determined between pieces of amplitude data on sample points, and timing data, regarding compressed data having a pair of difference data and timing data indicative of a time interval between sample points, said difference data being determined between pieces of amplitude data on a predetermined sample point that is extracted from data to be compressed.

38. The expanding method according to claim 36, **characterized in that** an interpolating operation for determining said interpolation data is a linear interpolating operation.

39. The expanding method according to claim 36, **characterized in that** expansion data is obtained by performing an operation reversed from a rounding operation, which is performed for compressing said data to be compressed, on interpolation data obtained by said interpolation.

40. The expanding method according to claim 39, **characterized in that** said operation reversed from said rounding operation is performed by an operation having a nonlinear relationship between data values before and after said reverse rounding operation.

41. The expanding method according to claim 40, **characterized in that** said operation having a nonlinear relationship is based on a logarithmic function or an approximate function.

42. The expanding method according to claim 36, **characterized in that** when timing data constituting said compressed data has a value of 0, said expansion data is set at 0 for a time interval indicated by a value of amplitude data.

43. An expanding device **characterized by** comprising interpolating means for interpolating pieces of amplitude data having a time interval indicated by timing data, by using amplitude data on each sample point and timing data between sample points, regarding compressed data having a pair of amplitude data on a predetermined sample point that is extracted from data to be compressed and timing data indicative of a time interval between sample points.

44. An expanding device **characterized by** comprising interpolating means for interpolating pieces of amplitude data having a time interval indicated by timing data, by using difference data, which is determined between pieces of amplitude data on sample points, and timing data, regarding compressed data having a pair of difference data and timing data indicative of a time interval between sample points, said difference data being determined between pieces of amplitude data on a predetermined sample point that is extracted from data to be compressed.

45. The expanding device according to claim 43, **characterized in that** an interpolating operation performed by said interpolating means is a linear interpolating operation.

46. The expanding device according to claim 43, further comprising reverse rounding means for performing an operation reversed from a rounding operation, which is performed for compressing said data to be compressed, on interpolation data obtained by said interpolation.

47. The expanding device according to claim 46, **characterized in that** said operation reversed from said rounding operation is performed by an operation having a nonlinear relationship between data values before and after said reverse rounding operation.

48. The expanding device according to claim 47, **characterized in that** said operation having a nonlinear relationship is based on a logarithmic function or an approximate function.

49. The expanding device according to claim 43, **characterized by** when timing data constituting said compressed data has a value of 0, means for setting said expansion data at 0 for a time interval indicated by a value of amplitude data.

50. A compressing and expanding system, **characterized in that** on a compression side, a sampled point, on which an error from original data is at a desired value or smaller when interpolation is performed on two pieces of sampled data included in data to be compressed, is sequentially detected as a sample point, and compressed data is generated by using sampled data on each detected sample point, and
    on an expansion side, sampled data on said sample point is obtained from said compressed data, an interpolating operation is performed, and expansion data is obtained by determining interpolation data for interpolating said sample points.

51. A compressing and expanding system **characterized in that** on a compression side, data to be compressed is sampled at a time interval on a sampled point having an error at a desired value or smaller between a data value on a straight line for connecting two pieces of sampled data included in data to be compressed and a sampled data value on the same sampled point as the data value on the straight line, and a pair of discrete amplitude data on each sample point and timing data indicative of a time interval between sample points is obtained as compressed data, and
    on an expansion side, expansion data is obtained by determining interpolation data for linearly interpolating pieces of amplitude data having a time interval indicated by timing data, by using amplitude data on each sample point and timing data between sample points that are included in said compressed data.

52. The compressing and expanding system according to claim 50, **characterized in that** on the compression side, a rounding operation is performed for rounding a lower-order bit of said data to be compressed or amplitude data on said sample point, and a pair of amplitude data on said rounded sample point and timing data indicative of a time interval between sample points is obtained as compressed data.

53. The compressing and expanding system according to claim 50, **characterized in that** on the compression side, a pair of amplitude difference data and timing data indicative of a time interval between sample points is obtained as compressed data, said amplitude difference data being obtained by computing difference between pieces of amplitude data on said sample points.

54. The compressing and expanding system according to claim 52, **characterized in that** on the expansion side, expansion data is obtained by performing an operation reversed from a rounding operation, which is performed on said compression side, on interpolation data obtained by said interpolation.

55. The compressing and expanding system according to claim 53, **characterized in that** on the expansion side, expansion data is obtained by determining interpolation data for interpolating pieces of amplitude data having a time interval indicated by said timing data, by using said amplitude difference data and said timing data.

56. The compressing and expanding system according to claim 50, **characterized in that** on the compression side, sampled data having amplitude smaller than a predetermined value is handled as a mute part in said data to be compressed, a value of timing data is set at 0 regarding said compressed data on said mute part, and a value of amplitude data is set at a value indicative of a time interval of a mute state, and

on the expansion side, when said timing data constituting said compressed data has a value of 0, said expansion data is set at 0 for a time interval indicated by a value of said amplitude data.

57. A recording medium being capable of computer reading, **characterized by** recording a program for causing a computer to carry out the steps of said compressing method according to claim 1.

58. A recording medium being capable of computer reading, **characterized by** recording a program for causing a computer to carry out the steps of said expanding method according to claim 36.

59. A recording medium being capable of computer reading, **characterized by** recording a program for causing a computer to function as said means according to claim 19.

60. A recording medium being capable of computer reading, **characterized by** recording a program for causing a computer to function as said means according to claim 43.

61. A recording medium being capable of computer reading, **characterized by** recording a program for causing a computer to realize the function of said compressing and expanding system according to claim 50.

62. A compressing program **characterized by** causing a computer to carry out the steps of said compressing method according to claim 1.

63. An expanding program **characterized by** causing a computer to carry out the steps of said expanding method according to claim 36.

64. A compressing program **characterized by** causing a computer to function as said means according to claim 19.

65. An expanding program **characterized by** causing a computer to function as said means according to claim 43.

66. The compressing device according to claim 19, further comprising mute processing means for replacing sampled data having an absolute value smaller than a predetermined value with zero data in said data to be compressed, and rounding means for rounding a lower-order bit of said data to be compressed or amplitude data on said sample point.

67. The compressing device according to claim 19, further comprising mute processing means for replacing sampled data having an absolute value smaller than a predetermined value with zero data in said data to be compressed, and difference computing means for computing difference between pieces of amplitude data on said sample point.

68. The compressing device according to claim 19, further comprising rounding means for rounding a lower-order bit of said data to be compressed or amplitude data on said sample point, and difference computing means for computing difference between pieces of amplitude data on said sample point.

69. The compressing device according to claim 19, further comprising mute processing means for replacing sampled data having an absolute value smaller than a predetermined value with zero data in said data to be compressed, rounding means for rounding a lower-order bit of said data to be compressed or amplitude data on said sample point, and difference computing means for computing difference between pieces of amplitude data on said sample point.

# F I G. 1A

BETWEEN D1 AND D7

# F I G. 1B

BETWEEN D1 AND D6

EP 1 289 152 A1

# F I G. 2.

# F I G. 3

# F I G. 4

# FIG. 5A

$D3''>$ → D → D → D → D → $D3''$
→ 2D3''
→ 3D3''
→ 4D3''
→ 5D3''

# FIG. 5B

$D4''>$ → D → D → D → D → $D4''$
→ 2D4''
→ 3D4''
→ 4D4''
→ 6D4''
→ 8D4''

# FIG. 5C

$D5''>$ → D → D → D → D → $D5''$
→ 2D5''
→ 3D5''
→ 4D5''
→ 6D5''
→ 9D5''

# FIG. 5D

$D6''>$ → D → D → D → D → $D6''$
→ 2D6''
→ 3D6''
→ 4D6''
→ 6D6''
→ 8D6''

# FIG. 5E

$D7''>$ → D → D → D → D → $D7''$
→ 2D7''
→ 3D7''
→ 4D7''
→ 5D7''

EP 1 289 152 A1

F I G. 6A

F I G. 6B

F I G. 6C

F I G. 6D

F I G. 6E

# F I G. 7

TIMING
CLOCK
OUTPUT

# F I G. 8

CLOCK

C6

①

②

③

④

⑤

⑥

⑦

⑧

# F I G. 9A

D3

D2

e2

D2'

$$\frac{D3-D1}{2}$$

D1

CLK

# F I G. 9B

D4

D2        D3''

e2        e3

D3

D2''

$$\frac{1}{3}(D4-D1)$$    $$\frac{2}{3}(D4-D1)$$

D1

# F I G. 10

66

AMPLITUDE
DATA

61    62    63    64    65

D    +    +    D    ÷

−    +

RST

TIMING
DATA

+
+

EXPANSION
DATA

# F I G. 11

# F I G. 12

# F I G. 13

# F I G. 14

AMPLITUDE DIFFERENCE DATA

TIMING DATA

CLOCK INPUT

CLK

DATA MEMORY ~12

INTERPOLATING SECTION ~15

REVERSE ROUNDING SECTION ~16

D/A CONVERTING SECTION ~14

LPF ~17

ANALOG OUTPUT

TIMING GENERATING SECTION ~11

EP 1 289 152 A1

# F I G. 15

# F I G. 16

# F I G. 17

# F I G. 18

AMPLITUDE
DIFFERENCE
DATA

AMPLITUDE
DATA

# F I G. 19

ORIGINAL
DATA
INPUT

16

16

16 — MSB — 91 — 16

93-1

12

92-2

93-2

10

92-3

93-3

8

92-4

93-4

6

92-5

LSB

94-1
219+
(37/12252)   16   8

ROUNDING
OUTPUT

8

95-1

94-2
183+
(36/3072)   16   8

95-2

94-3
146+
(37/768)   16   8

95-3

94-4
110+
(36/192)   16   8

95-4

94-5
(63/110)   16   8

95-5

# F I G. 20

AMPLITUDE
DATA

AMPLITUDE
DIFFERENCE 63
DATA

64   65   66   67   68   EXPANSION
                                    DATA

+        D        ÷        +        ×
+

RST   TIMING
      DATA

AMPLITUDE
DATA

# F I G. 21

AMPLITUDE
DATA
INPUT

EXPANSION
DATA
OUTPUT

101-1
A
COMP
B A>B=1
103-1
104-1
4096+
(12252/37)
16
105-1
16

219
8
8
8

101-2
A
COMP
B A>B=1
102-2
103-2
104-2
1024+
(3072/36)
16
105-2

183
8
8

101-3
A
COMP
B A>B=1
102-3
103-3
104-3
256+
(768/37)
16
105-3

146
7
8

101-4
A
COMP
B A>B=1
102-4
103-4
104-4
64+
(192/36)
16
105-4

110
7
8

8

104-5
(110/64)
16
105-5

8

# F I G. 22A

─ REPRODUCED DATA
─ ORIGINAL DATA

# F I G. 22B

# F I G. 23A

REPRODUCED DATA
ORIGINAL DATA

# F I G. 23B

EP 1 289 152 A1

## F I G. 24A

—REPRODUCED DATA
—ORIGINAL DATA

## F I G. 24B

## INTERNATIONAL SEARCH REPORT

| | International application No. |
|---|---|
| | PCT/JP01/04250 |

| A. CLASSIFICATION OF SUBJECT MATTER |
|---|
| Int.Cl$^7$ H03M7/30 |

According to International Patent Classification (IPC) or to both national classification and IPC

| B. FIELDS SEARCHED |
|---|
| Minimum documentation searched (classification system followed by classification symbols) |
| Int.Cl$^7$ H03M7/30 |

Documentation searched other than minimum documentation to the extent that such documents are included in the fields searched

Jitsuyo Shinan Koho (Y1, Y2)  1926-1996  Toroku Jitsuyo Shinan Koho (U)  1994-2001
Kokai Jitsuyo Shinan Koho (U)  1971-2001  Jitsuyo Shinan Toroku Koho (Y2) 1996-2001

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| A | JP 59-096513 A (Nippon Gakki Seizou K.K.), 04 June, 1984 (04.06.84), Fig. 1 (Family: none) | 1~69 |
| A | JP 3-192400 A (Gakken Co., Ltd.), 22 August, 1991 (22.08.91), Fig. 1 (Family: none) | 1~69 |
| A | JP 4-061509 A (Alpine Electronics, Inc.), 27 February, 1992 (27.02.92), Fig. 1 (Family: none) | 1~69 |
| A | JP 10-126275 A (Matsushita Electric Ind. Co., Ltd.), 15 May, 1998 (15.05.98), Fig. 1 & EP 0822517 A2 | 1~69 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 August, 2001 (09.08.01) | 21 August, 2001 (21.08.01) |

| Name and mailing address of the ISA/ | Authorized officer |
|---|---|
| Japanese Patent Office | |
| Facsimile No. | Telephone No. |

Form PCT/ISA/210 (second sheet) (July 1992)